# EUROPEAN PATENT APPLICATION

(11) **EP 4 694 177 A1**
(43) Date of publication of application: **11.02.2026**
(21) Application number: 24779755.8
(22) Date of filing: 19.03.2024
(51) Int. Cl.: H04N 25/79, H01L 27/146, H04N 25/70, H04N 25/76

(54) **LIGHT DETECTION DEVICE AND ELECTRONIC APPARATUS**

(30) Priority: 24.03.2023 JP 2023048570
(71) Applicant: Sony Semiconductor Solutions Corporation, Atsugi-shi, Kanagawa 243-0014 (JP)
(72) Inventor: BANDO Masashi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/010785
(87) International publication number: WO 2024/203630

(57) **Abstract**

[Problem] To accomplish higher resolution and improvement of the image quality of a captured image.

[Solution] A light detection device includes a first substrate on which a plurality of pixels are arranged, a second substrate on which a plurality of first pixel circuits and a plurality of second pixel circuits are arranged, and a third substrate on which a logic circuit is arranged, with the first substrate, the second substrate, and the third substrate being laminated. The first substrate includes a plurality of first metal pads that are arranged opposite the second substrate and to which output nodes of the plurality of pixels are connected. The second substrate includes a semiconductor layer arranged opposite the third substrate, a plurality of second metal pads joined to the plurality of first metal pads, a plurality of first via holes arranged to penetrate the semiconductor layer from the plurality of second pixel circuit, and a plurality of third metal pads arranged opposite the third substrate and connected to the plurality of first via holes. The third substrate includes a plurality of fourth metal pads joined to the plurality of third metal pads. Each of the plurality of first via holes and at least one transistor in one or more of the first pixel circuits to which each of the plurality of first via holes correspond, or one or more of the second pixel circuits to which each of the plurality of first via holes correspond, are arranged on one axis.

## Description

### [Technical Field]

The present disclosure relates to a light detection device and an electronic apparatus.

### [Background Art]

A rolling shutter type imaging device that starts time-staggered exposure in units of pixel rows has a problem in that a mobile object image included in a captured image is imaged in a distorted manner. Therefore, a global shutter type imaging device that starts simultaneous exposure with all pixels has been proposed (see PTL 1).

### [Citation List]

### [Patent Literature]

[PTL 1]
WO 2021/215105 Specification

### [Summary]

### [Technical Problem]

In the global shutter type, it is necessary that each pixel be provided with a charge retention portion for retaining accumulated charges that are accumulated in photoelectric conversion elements of the respective pixels, hence the pixel size increases, which results in an obstacle to higher resolution. Further, it is necessary to devise a way to curb the impact of noise when retaining the accumulated charges of the photoelectric conversion elements in the charge retention portion.

Thus, the present disclosure provides a light detection device and an electronic apparatus that can accomplish higher resolution and improvement of the image quality of a captured image.

### [Solution to Problem]

In order to solve the above problem, according to the present disclosure, provided is a light detection device, including:
a plurality of pixels, each of which accumulates a charge corresponding to an amount of incident light;
a plurality of first pixel circuits that have a plurality of capacitance elements that retain, at the same timing, voltage signals corresponding to charges accumulated in the plurality of pixels;
a plurality of second pixel circuits that generate pixel signals corresponding to charges retained by the plurality of capacitance elements;
a logic circuit that performs signal processing on the plurality of pixel signals generated by the plurality of second pixel circuits;
a first substrate on which the plurality of pixels are arranged;
a second substrate that is laminated on the first substrate and on which the plurality of first pixel circuits and the plurality of second pixel circuits are arranged; and
a third substrate that is laminated on the second substrate and on which the logic circuit is arranged, wherein
the first substrate includes a plurality of first metal pads that are arranged opposite the second substrate and to which output nodes of the plurality of pixels are connected,
the second substrate includes:
   a semiconductor layer arranged opposite the third substrate;
   a plurality of second metal pads joined to the plurality of first metal pads;
   a plurality of first via holes arranged to penetrate the semiconductor layer from the plurality of second pixel circuit; and
   a plurality of third metal pads arranged opposite the third substrate and connected to the plurality of first via holes, and
   the third substrate includes a plurality of fourth metal pads joined to the plurality of third metal pads,
   each of the plurality of first via holes is provided to correspond to one or more of the first pixel circuits and one or more of the second pixel circuits, and
   each of the plurality of first via holes and at least one transistor in the one or more of the first pixel circuits to which each of the plurality of first via holes correspond, or the one or more of the second pixel circuits to which each of the plurality of first via holes correspond, are arranged on one axis.

Each of the plurality of pixels may include:
a photoelectric conversion element that accumulates a charge corresponding to the amount of incident light;
a first transistor that switches between whether or not to transfer an accumulated charge of the photoelectric conversion element to a first floating diffusion region;
a second transistor that switches between whether or not to initialize a charge of the first floating diffusion region; and
a first source follower circuit that generates a voltage signal corresponding to the charge of the first floating diffusion region,
each of the plurality of first pixel circuits may include:
   a first capacitance element that retains a voltage signal output from the first source follower circuit in a state where the charge of the first floating diffusion region of the corresponding pixel is initialized;
   a second capacitance element that retains a voltage signal output from the first source follower circuit in a state where the accumulated charge of the photoelectric conversion element is transferred to the first floating diffusion region of the corresponding pixel;
   a third transistor that switches between whether or not to transfer a charge retained by the first capacitance element to a second floating diffusion region; and
   a fourth transistor that switches between whether or not to transfer a charge retained by the second capacitance element to the second floating diffusion region, and
   each of the plurality of second pixel circuits may include:
      a fifth transistor that switches between whether or not to initialize a charge of the second floating diffusion region; and
      a second source follower circuit that generates a pixel signal corresponding to the charge of the second floating diffusion region.

Each of the plurality of first via holes, the fifth transistor in the one or more of the second pixel circuits to which each of the plurality of first via holes corresponds, the second source follower circuit, and the fourth transistor, may be arranged on one axis.

Each of the plurality of first via holes and the first transistor and the second transistor in the one or more of the first pixel circuits to which each of the plurality of first via holes corresponds, may be arranged on one axis.

Each of the plurality of first pixel circuits may include a sixth transistor and a seventh transistor that precharge the first capacitance element and the second capacitance element, and
each of the plurality of first via holes and the sixth and seventh transistors in the first pixel circuit to which each of the plurality of first via holes corresponds, may be arranged on one axis.

Each of the plurality of pixels may include:
a third capacitance element that accumulates part of the accumulated charge of the photoelectric conversion element; and
an eighth transistor that switches between whether or not to accumulate part of the accumulated charge of the photoelectric conversion element in the third capacitance element.

Each of the plurality of pixels may include a ninth transistor that switches between whether or not to discharge the accumulated charge of the photoelectric conversion element.

A diffusion layer of the transistor on the one axis that is adjacent to each of the plurality of first via holes may be arranged between each of the plurality of first via holes and the transistor adjacent thereto on the one axis.

Each of the plurality of second pixel circuits may be shared by two or more of the pixels and two or more of the first pixel circuits.

A unit pixel group region that includes the two or more of the first pixel circuits, one of the second pixel circuits, and one of the first via holes may be provided, for each of the two or more of the pixels, and
in the unit pixel group region, the first via hole and at least one transistor in the two or more of the first pixel circuits and the one of the second pixel circuits may be arranged on one axis.

The second pixel circuit in the unit pixel group region may generate a pixel signal corresponding to a voltage signal retained by the plurality of capacitance elements, and the first via hole may transmit the pixel signals.

The unit pixel group region may include four of the first pixel circuits corresponding to a pixel group having two of the pixels in each of a first direction and a second direction, one of the second pixel circuits, and one of the first via holes, and
the plurality of first via holes corresponding to a plurality of the unit pixel group regions may be arranged at a substantially central portion of a boundary side of the unit pixel group region.

The unit pixel group region may include two of the first pixel circuits corresponding to a pixel group having one of the pixels in a first direction and two of the pixels in a second direction, one of the second pixel circuits, and one of the first via holes, and two of the unit pixel group regions arranged close to each other in the first direction may be arranged out of alignment with each other in the first direction.

The two of the unit pixel group regions arranged close to each other in the first direction may be arranged out of alignment in the first direction in such a manner that distances between the first via holes in the two unit pixel group regions and a transistor connected to the first via holes are equal.

Each of the plurality of second pixel circuits may be provided to correspond to any of the plurality of first pixel circuits, and
one of the first via holes may be arranged for each of the plurality of second pixel circuits.

Each of the plurality of first via holes may be arranged along a boundary side of two unit pixel regions adjacent to each other in the first direction or the second direction.

According to the present disclosure, provided is an electronic apparatus, comprising:
a light detection device that generates an image corresponding to an amount of incident light; and
a processing unit that processes the image, wherein
the light detection device includes:
   a plurality of pixels, each of which accumulates a charge corresponding to the amount of the incident light;
   a plurality of first pixel circuits that have a plurality of capacitance elements that retain, at the same timing, voltage signals corresponding to charges accumulated in the plurality of pixels;
   a plurality of second pixel circuits that generate pixel signals corresponding to the charges retained by the plurality of capacitance elements;
   a logic circuit that performs signal processing on the plurality of pixel signals generated by the plurality of second pixel circuits;
   a first substrate on which the plurality of pixels are arranged;
   a second substrate that is laminated on the first substrate and on which the plurality of first pixel circuits and the plurality of second pixel circuits are arranged; and
   a third substrate that is laminated on the second substrate and on which the logic circuit is arranged, wherein
   the first substrate includes a plurality of first metal pads that are arranged opposite the second substrate and to which output nodes of the plurality of pixels are connected,
   the second substrate including:
      a semiconductor layer arranged opposite the third substrate;
      a plurality of second metal pads joined to the plurality of first metal pads;
      a plurality of first via holes arranged to penetrate the semiconductor layer from the plurality of second pixel circuit; and
      a plurality of third metal pads arranged opposite the third substrate and connected to the plurality of first via holes, and
      the third substrate including a plurality of fourth metal pads joined to the plurality of third metal pads,
      each of the plurality of first via holes is provided to correspond to one or more of the first pixel circuits and one or more of the second pixel circuits, and
      each of the plurality of first via holes and at least one transistor in the one or more of the first pixel circuits to which each of the plurality of first via holes correspond, or the one or more of the second pixel circuits to which each of the plurality of first via holes correspond, may be arranged on one axis.

### [Brief Description of Drawings]

[Fig. 1]

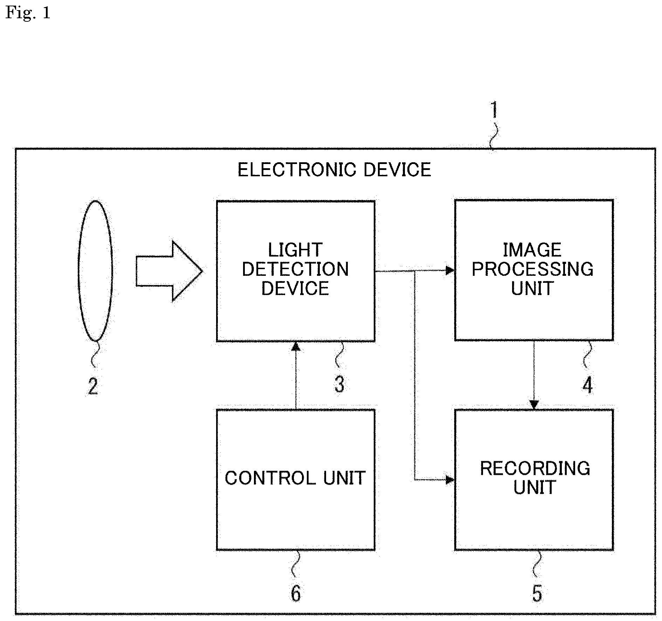

   Fig. 1 is a block diagram of an electronic apparatus according to a first embodiment of the present disclosure.
[Fig. 2]

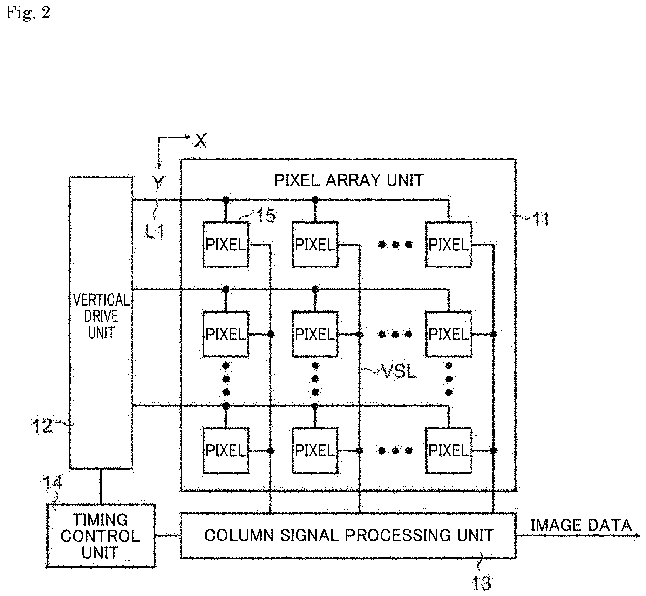

   Fig. 2 is a block diagram showing an overview configuration of a light detection device according to an embodiment.
[Fig. 3]

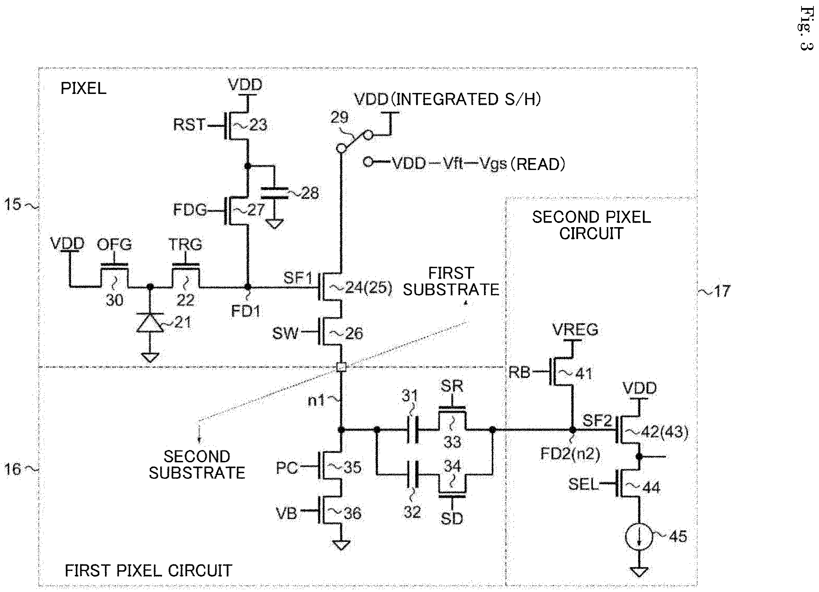

   Fig. 3 is a circuit diagram of a pixel and a pixel circuit inside a pixel array unit.
[Fig. 4]

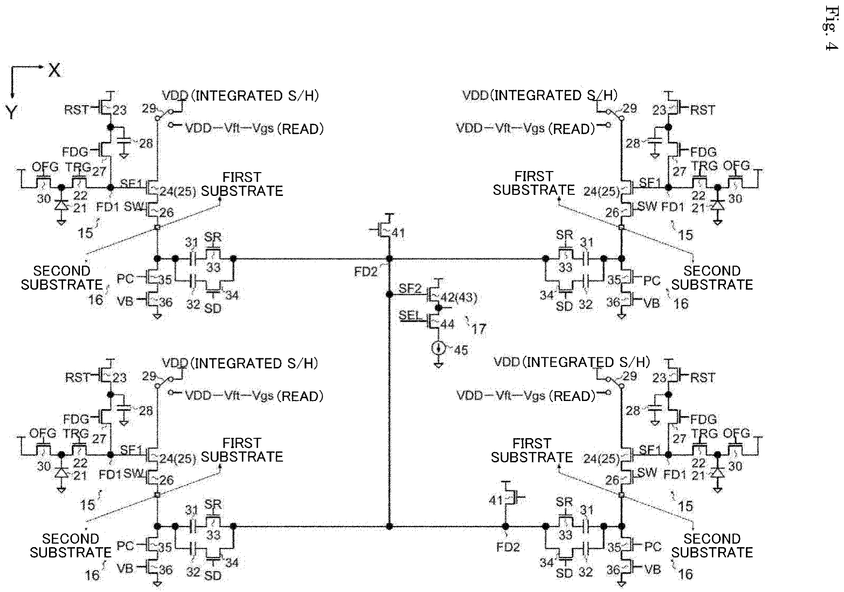

   Fig. 4 is a circuit diagram showing an example in which four pixels and four first pixel circuits share one second pixel circuit.
[Fig. 5]

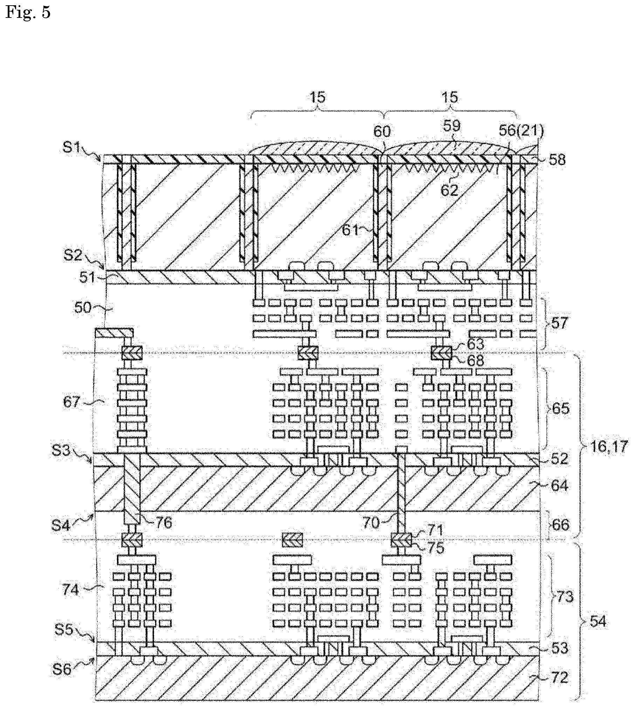

   Fig. 5 is a cross-sectional view showing a cross-sectional structure of the light detection device according to an embodiment.
[Fig. 6]

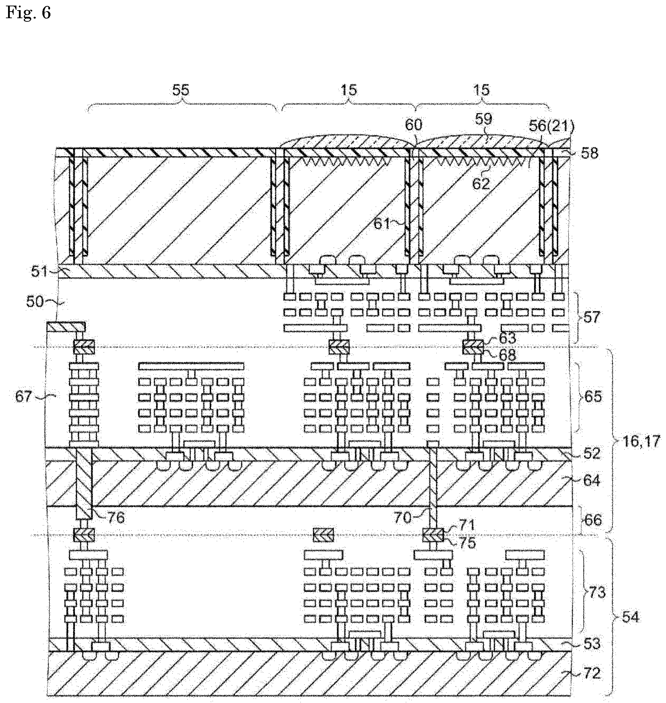

   Fig. 6 is a cross-sectional view showing a first example of a cross-sectional structure of a peripheral circuit of a pixel.
[Fig. 7]

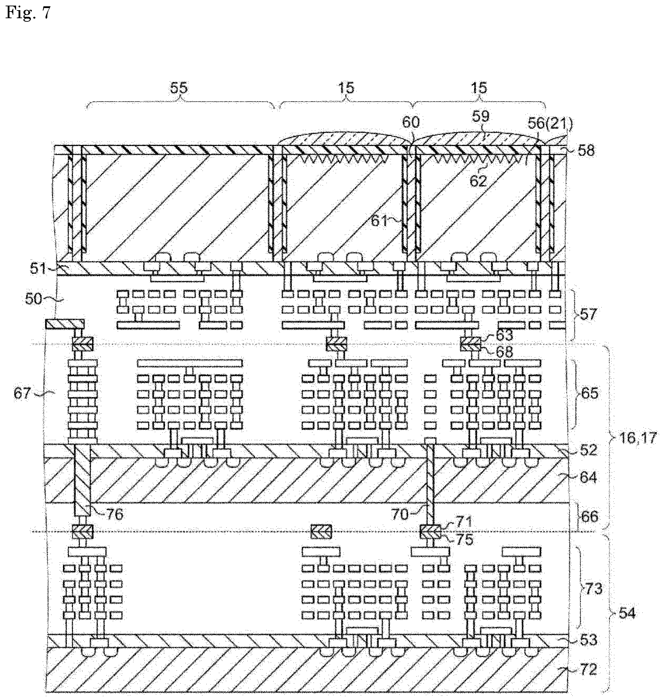

   Fig. 7 is a cross-sectional view showing a second example of the cross-sectional structure of the peripheral circuit of the pixel.
[Fig. 8]

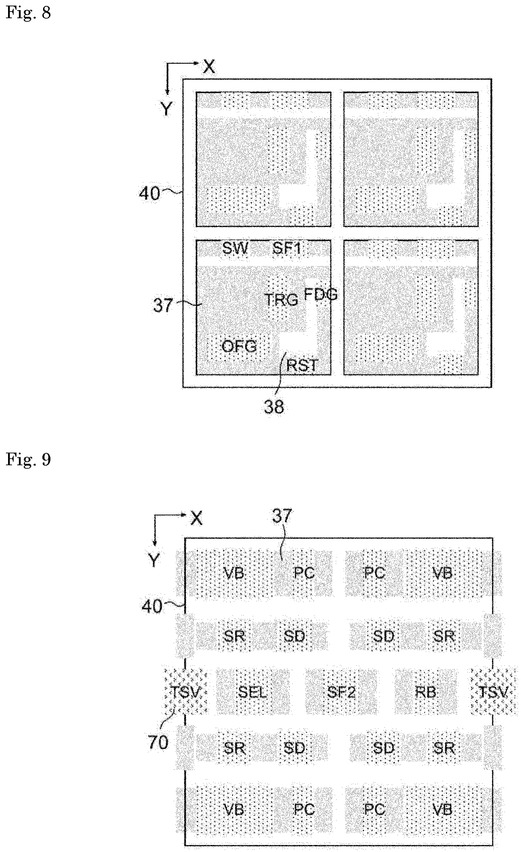

   Fig. 8 is a plan layout view of 2×2 pixels on a first substrate in a case where four pixels and four first pixel circuits share one second pixel circuit.
[Fig. 9]
   Fig. 9 is a plan layout view of a unit pixel group region for 2×2 pixels on a second substrate laminated on the first substrate shown in Fig. 8.
[Fig. 10]

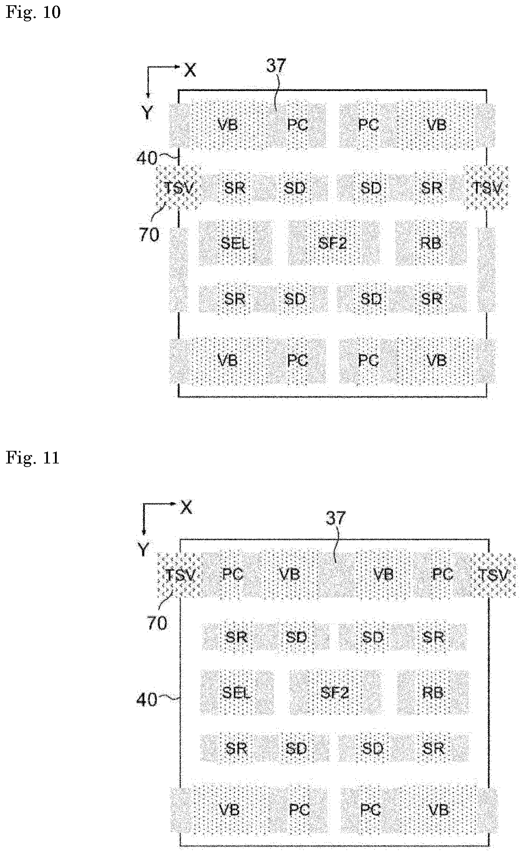

   Fig. 10 is a plan layout view of the second substrate according to a first modification of Fig. 9.
[Fig. 11]
   Fig. 11 is a plan layout view of the second substrate according to a second modification of Fig. 9.
[Fig. 12]

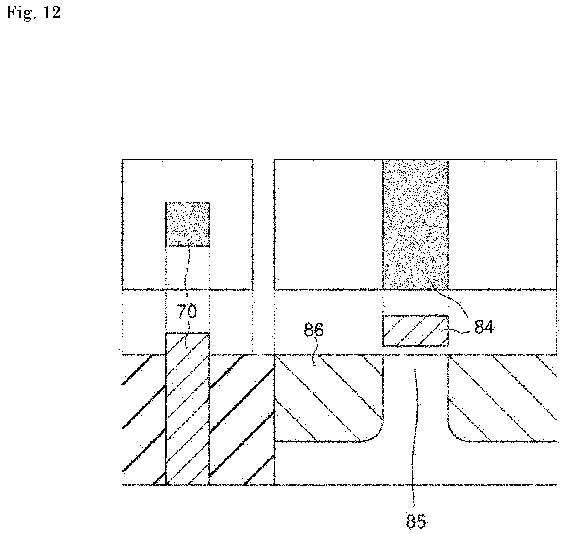

   Fig. 12 is a diagram schematically showing a cross-sectional structure around a TSV.
[Fig. 13]

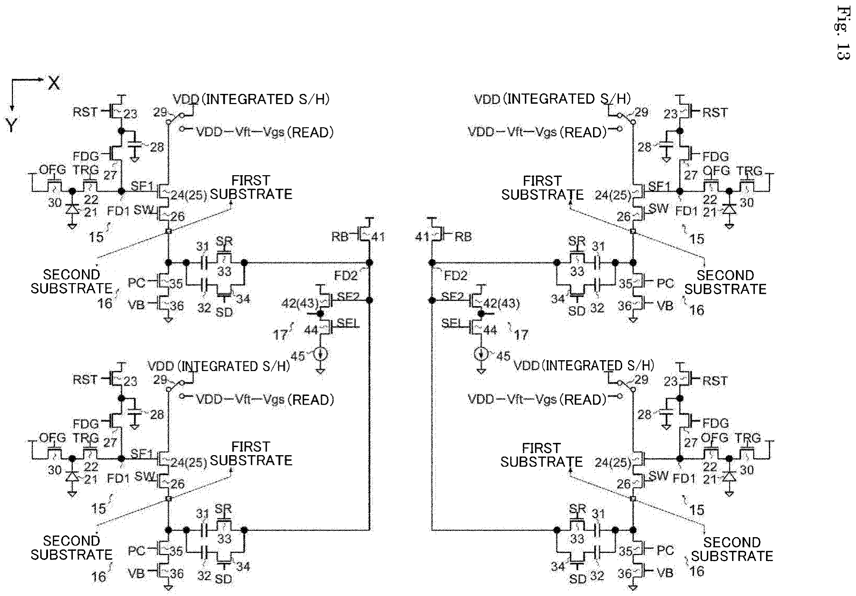

   Fig. 13 is a circuit diagram where two pixels and two first pixel circuits share one second pixel circuit using the pixels, the first pixel circuit, and the second pixel circuit of the circuit configuration shown in Fig. 3.
[Fig. 14]

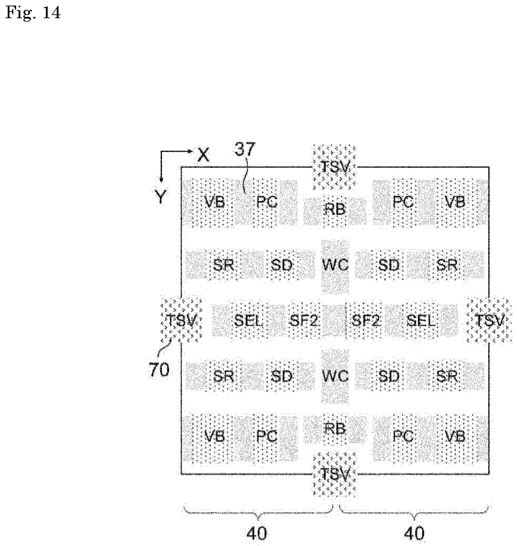

   Fig. 14 is a plan layout view of a region in which two unit pixel group regions for 1×2 pixels are arranged on the second substrate composed of a pixel and a pixel circuit shown in Fig. 31.
[Fig. 15]

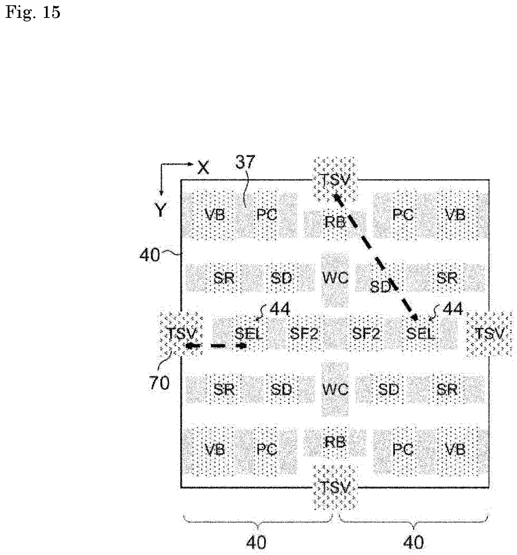

   Fig. 15 is a diagram for explaining the distance between the TSV and a source of a second selection transistor.
[Fig. 16]

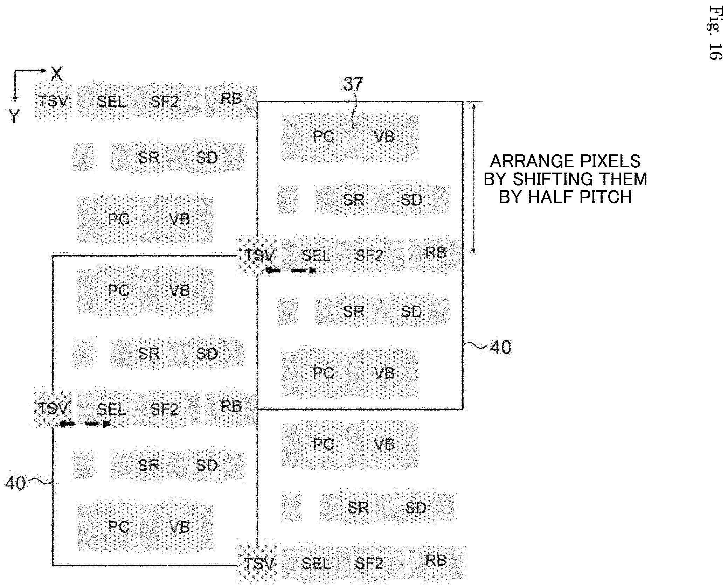

   Fig. 16 is a plan layout view showing a measure to suppress variations in wiring load and parasitic capacitance of wiring connected to the TSV.
[Fig. 17]

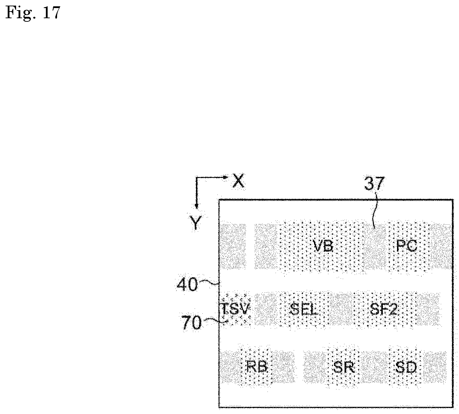

   Fig. 17 is a plan layout view of a second substrate of non-pixel sharing.
[Fig. 18]

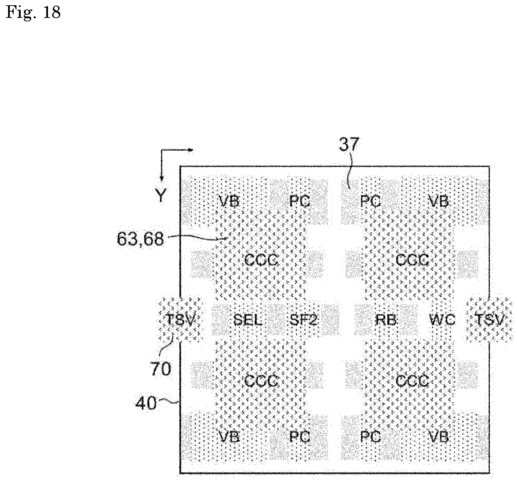

   Fig. 18 is a plan layout view showing an example of a location in the second substrate where a first metal pad and a second metal pad are joined, and a location in the second substrate where the TSV is arranged.
[Fig. 19]

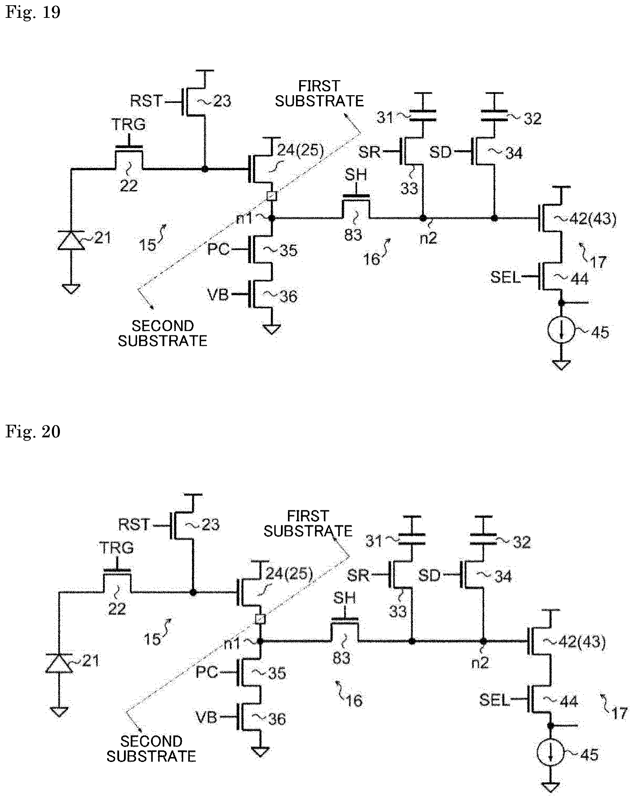

   Fig. 19 is a circuit diagram of a pixel, a first pixel circuit, and a second pixel circuit according to a first modification.
[Fig. 20]
   Fig. 20 is a circuit diagram of a pixel, a first pixel circuit, and a second pixel circuit according to a second modification.
[Fig. 21]

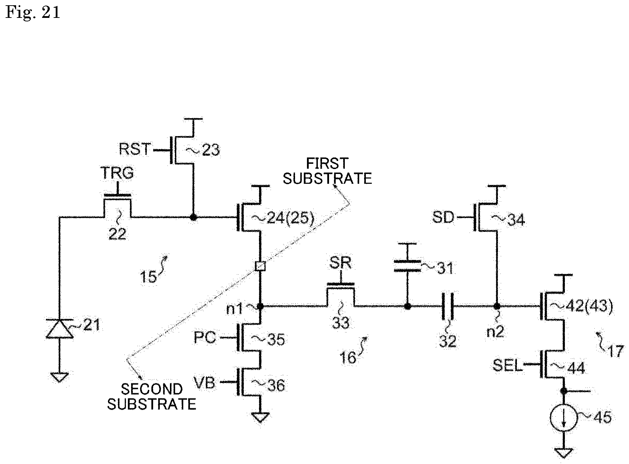

   Fig. 21 is a circuit diagram of a pixel, a first pixel circuit, and a second pixel circuit according to a third modification.
[Fig. 22]

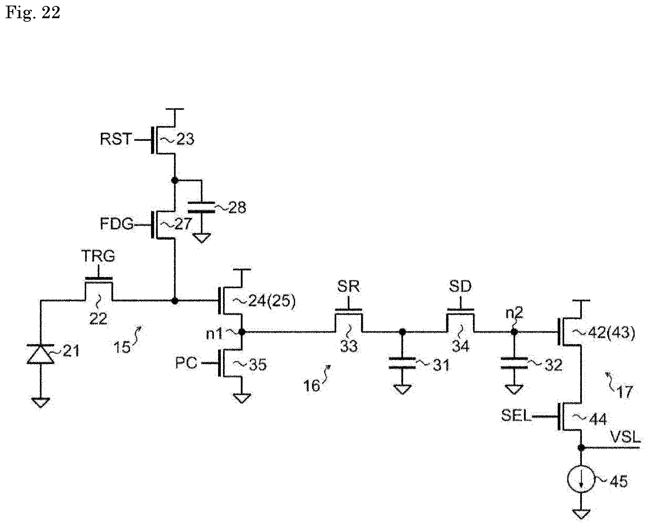

   Fig. 22 is a circuit diagram of a pixel, a first pixel circuit, and a second pixel circuit according to a fourth modification.
[Fig. 23]

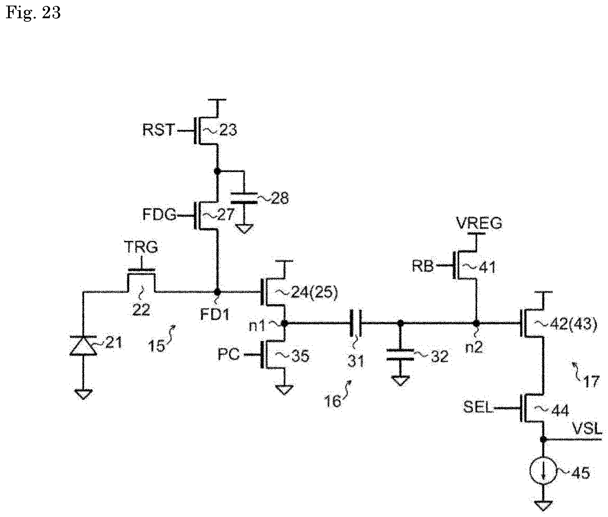

   Fig. 23 is a circuit diagram of a pixel, a first pixel circuit, and a second pixel circuit according to a fifth modification.
[Fig. 24]

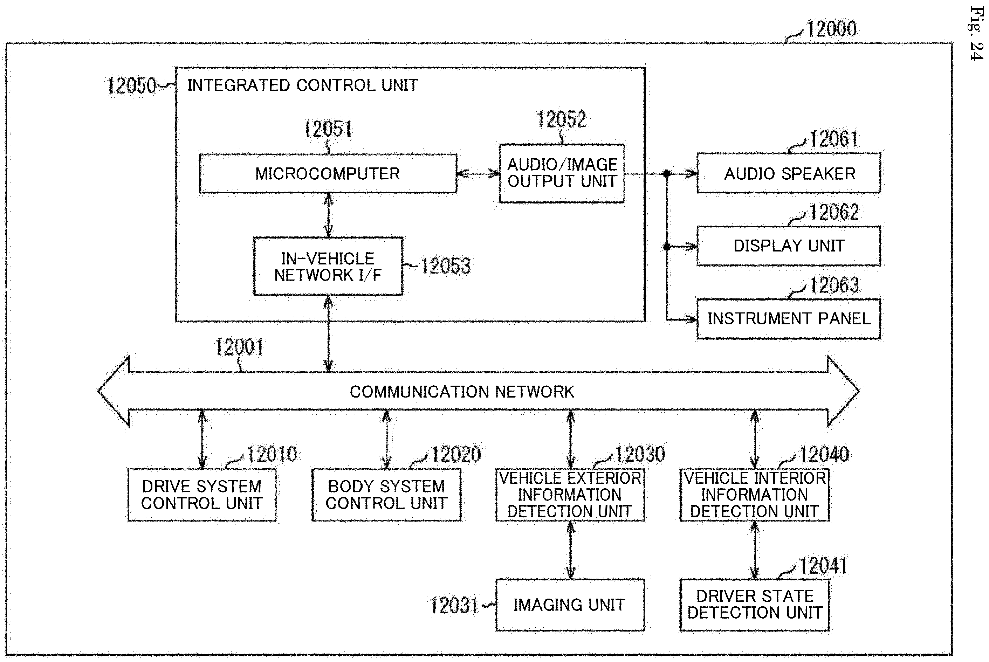

   Fig. 24 is a block diagram showing an example of an overview configuration of a vehicle control system.
[Fig. 25]

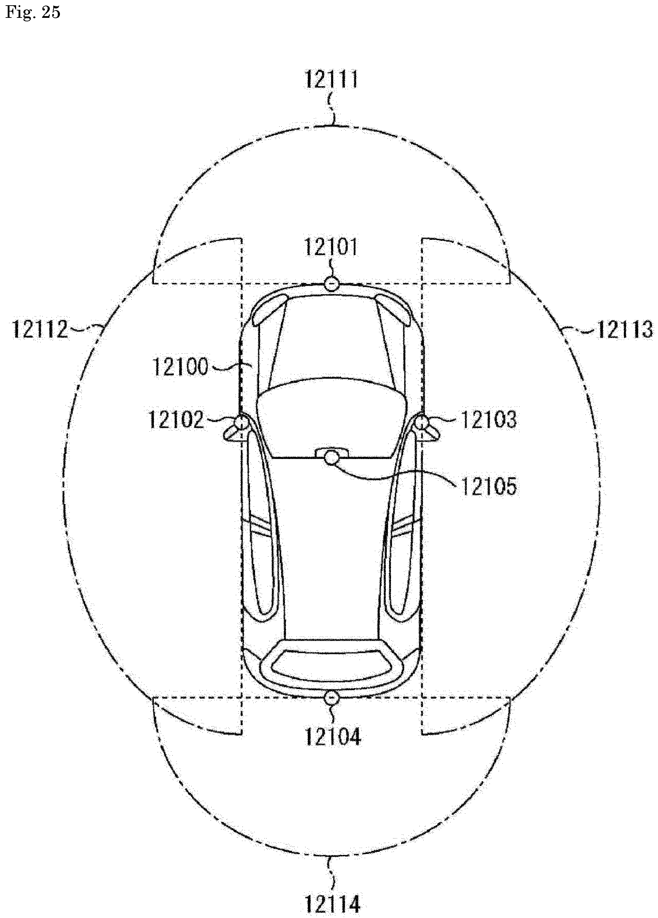

   Fig. 25 is an explanatory diagram showing an example of positions at which a vehicle exterior information detection unit and an imaging unit are installed.
[Fig. 26]

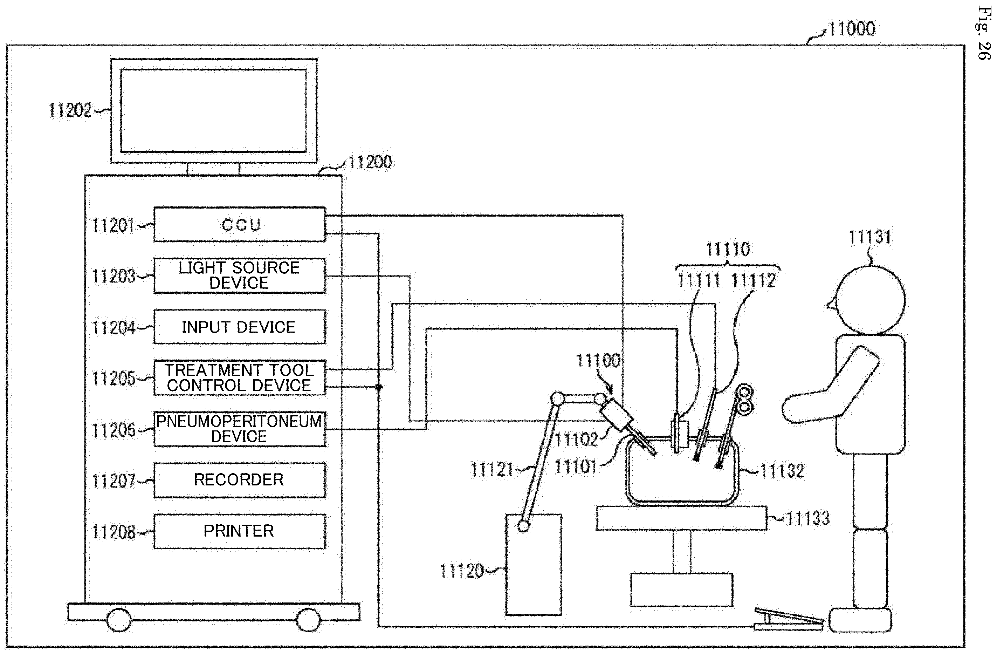

   Fig. 26 is a diagram showing an example of an overview configuration of an endoscopic surgery system.
[Fig. 27]

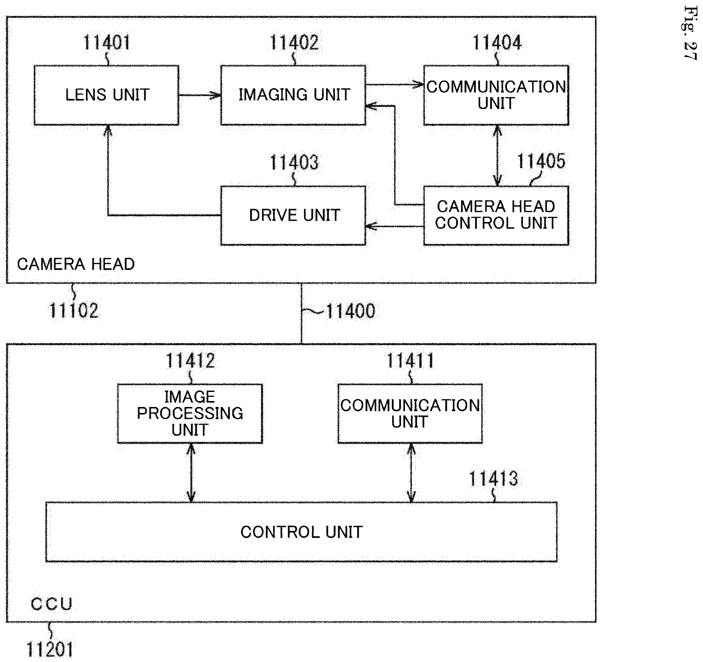

   Fig. 27 is a block diagram showing an example of functional configurations of a camera head and a CCU.

### [Description of Embodiments]

Hereinafter, embodiments of a light detection device and an electronic apparatus will be described with reference to the drawings. Although main components of the light detection device and the electronic apparatus will be mainly described below, the light detection device and the electronic apparatus may include components and functions that are not illustrated or explained. The following descriptions are not intended to exclude any components or functions that are not illustrated or explained.

Fig. 1 is a block diagram showing an electronic apparatus 1 according to a first embodiment of the present disclosure. The electronic apparatus 1 has a function of generating an image corresponding to the luminance of incident light. The electronic apparatus 1 shown in Fig. 1 includes an imaging lens 2, a light detection device 3, an image processing unit 4, a recording unit 5, and a control unit 6. Although the electronic apparatus 1 is applicable to, for example, surveillance cameras, cameras mounted on industrial robots, or cameras for general use, the electronic apparatus 1 may be used in any specific applications and configurations.

The imaging lens 2 collects incident light and guides the incident light to the light detection device 3. The light detection device 3 images the incident light. The light detection device 3 has a function of generating a captured image by performing photoelectric conversion on light in a predetermined wavelength range such as visible light or infrared light. The captured image generated by the light detection device 3 is sent to the image processing unit 4 and the recording unit 5.

The image processing unit 4 executes predetermined image processing on the captured image, such as color or luminance adjustment, image compression, image recognition, tracking, or analysis. An image processed by the image processing unit 4 is output to the recording unit 5.

The recording unit 5 records the image output from the light detection device 3 or the image processing unit 4. The recording unit 5 may also be arranged on a server or the like connected over a network. In the electronic apparatus 1 according to the present embodiment, at least either the image processing unit 4 or the recording unit 5 shown in Fig. 1 can be omitted.

The control unit 6 controls an operation of the light detection device 3. Further, although not specifically stated in Fig. 1, the control unit 6 may control the image processing unit 4 and the recording unit 5.

Fig. 2 is a block diagram showing an overview configuration of the light detection device 3 according to an embodiment. The light detection device 3 according to an embodiment includes a pixel array unit 11, a vertical drive unit 12, a column signal processing unit 13, and a timing control unit 14, as shown in Fig. 2.

The pixel array unit 11 includes a plurality of pixels 15 arranged in a first direction (e.g., a row direction) X and a second direction (e.g., a vertical direction) Y. Although not shown in Fig. 2, a pixel circuit is connected to each of the pixels 15. Detailed configurations of the pixels 15 and pixel circuits will be described later.

The vertical drive unit 12 sequentially selects and drives each of a plurality of pixel groups (e.g., pixel rows) arranged in the first direction X of the pixel array unit 11. More specifically, a plurality of row selection lines L1 are connected to the vertical drive unit 12. Each of the plurality of row selection lines L1 is used to drive a corresponding pixel row.

A vertical signal line VSL is connected to each of the plurality of pixel groups (e.g., pixel columns) arranged in the second direction Y of the pixel array unit 11. Each vertical signal line VSL transmits a pixel signal generated by the pixel circuit connected to each pixel 15. The plurality of vertical signal lines VSL are connected to the column signal processing unit 13.

The column signal processing unit 13 performs analog-to-digital conversion of the pixel signal transmitted by each vertical signal line VSL, to generate a digital pixel signal. The column signal processing unit 13 is controlled by a horizontal drive unit, not shown, and sequentially outputs digital pixel signals.

The timing control unit 14 controls the timing of the vertical drive unit 12 and the column signal processing unit 13.

As will be described later, the light detection device 3 according to one embodiment is configured by laminating three semiconductor substrates (referred to as a first substrate, a second substrate, and a third substrate). The respective pixels 15 and pixel circuits of the pixel array unit 11 are separately arranged on the first substrate and the second substrate. In the present specification, of the pixels 15 and pixel circuits, the ones arranged on the first substrate are referred to as the pixels 15 and the ones arranged on the second substrate are referred to as the pixel circuits, but the boundary between the pixels 15 and the pixel circuits is not clearly defined; thus, in the present specification, the pixels 15 and the pixel circuits may be collectively called "pixel 15."

Fig. 3 is a circuit diagram of a pixel 15 and a pixel circuit inside the pixel array unit 11. The present embodiment adopts a pixel sharing method in which a part of a pixel circuit connected to the pixel 15 is shared by a plurality of pixels 15. In the present specification, of the pixel circuit, a circuit portion provided for each pixel 15 is referred to as a first pixel circuit 16, and a circuit portion shared by a plurality of pixels 15 is referred to as a second pixel circuit 17.

As shown in Fig. 3, the pixel 15 has a photoelectric conversion element 21, a transfer transistor 22, a first reset transistor 23, a first amplification transistor 25 configuring a first source follower circuit (SF1) 24, and a first selection transistor 26. Although Fig. 3 shows an example in which all of the transistors inside the pixel 15 and pixel circuits are configured by NMOS (N-channel Metal Oxide Semiconductor) transistors, at least some of the transistors may be configured by PMOS (P-channel MOS) transistors.

The photoelectric conversion element 21 is, for example, a photodiode. The photoelectric conversion element 21 accumulates a charge corresponding to the amount of incident light.

In the photoelectric conversion element 21, all pixels 15 start exposure at the same timing. The transfer transistor 22 transfers the charge accumulated in the photoelectric conversion element 21 to a first floating diffusion region FD1 at the same timing relative to all pixels 15. The first floating diffusion region FD1 is set to a reset state in which a charge is discharged, or a state in which a charge accumulated in the photoelectric conversion element 21, that is, a signal charge, is transferred. The transfer transistor 22 is turned ON when a TRG signal is at a high level. As described above, the TRG signals of all the pixels 15 change to the high level at the same timing.

The first reset transistor 23 discharges the charge accumulated in the photoelectric conversion element 21 and a charge of the first floating diffusion region FD1 before the photoelectric conversion element 21 starts a photoelectric conversion operation (sometimes referred to as an exposure operation, hereinafter). The first reset transistor 23 is turned ON when an RST signal is at a high level.

In Fig. 3, a conversion efficiency switching transistor 27 and a charge retaining unit 28 are arranged between the first reset transistor 23 and the first floating diffusion region FD1, but the conversion efficiency switching transistor 27 and the charge retaining unit 28 can be omitted. The charge retaining unit 28 is connected between a drain of the conversion efficiency switching transistor 27 and a reference voltage node (e.g., a ground voltage node). By holding part of the charge accumulated in the photoelectric conversion element 21 in the charge retaining unit 28 via the conversion efficiency switching transistor 27, more accumulated charges can be held, and the dynamic range can be expanded. The conversion efficiency switching transistor 27 is turned ON when an FDG signal is at a high level, and causes the charge retaining unit 28 to hold the charge accumulated in the photoelectric conversion element 21.

The first amplification transistor 25 configuring the first source follower circuit 24 generates a voltage signal according to the accumulated charge of the first floating diffusion region FD1. When the first selection transistor 26 is turned ON, the above-described voltage signal is sent to the first pixel circuit 16.

A drain of the first amplification transistor 25 may be connected to a power supply voltage node or may be connected to a voltage switching device 29 as shown in Fig. 3. The voltage switching device 29 switches and connects the drain of the first amplification transistor 25 to either a first reference voltage node or a second reference voltage node. The voltage switching device 29 selects the first reference voltage node when a voltage signal corresponding to a reset charge or accumulated charge by the photoelectric conversion is held in a first capacitance element or a second capacitance element described later, and selects the second reference voltage node when a pixel signal is read from the second pixel circuit 17 to the vertical signal line VSL. The first reference voltage node has a higher voltage level than the second reference voltage node.

The first selection transistor 26 is turned ON when an SW signal is at a high level. When the first selection transistor 26 is turned ON, a voltage signal of the first floating diffusion region FD1 is supplied to the first pixel circuit 16. In the present specification, a source of the first selection transistor is referred to as an output node n1 of the pixel 15.

The pixel 15 may include a discharge transistor 30. The discharge transistor 30 is turned ON when an OFG signal is at a high level, and discharges a charge overflowing from the photoelectric conversion element 21.

As shown in Fig. 3, the first pixel circuit 16 includes a first capacitance element 31, a second capacitance element 32, a first sampling transistor 33, and a second sampling transistor 34.

The first capacitance element 31 and the first sampling transistor 33 are connected in series between the output node n1 of the pixel 15 and a second floating diffusion region FD2. The second capacitance element 32 and the second sampling transistor 34 are connected in series between the output node n1 of the pixel 15 and the second floating diffusion region FD2.

The first capacitance element 31 holds a voltage signal when the first floating diffusion region FD1 is in a reset state when the first sampling transistor 33 is ON. The first sampling transistor 33 is turned ON when an SR signal is at a high level. The second capacitance element 32 holds a voltage signal in a state where a signal charge is accumulated in the first floating diffusion region FD1 when the second sampling transistor 34 is ON. The second sampling transistor 34 is turned ON when an SD signal is at a high level.

The first capacitance element 31 and the second capacitance element 32 are formed in, for example, an MIM (Metal Insulator Metal) structure. For example, by forming recesses and protrusions on a part of the semiconductor layer and laminating a metal layer, an insulating layer, and a metal layer along the surface having the recesses and protrusions, the first capacitance element 31 and the second capacitance element 32 of the MIM structure can be formed by a semiconductor process. By increasing the number of recesses and protrusions, the surface area of the metal layer can be increased and the capacity can be increased.

The first pixel circuit 16 includes a current source connected between the output node n1 of the pixel 15 and the reference voltage node (e.g., ground voltage node). This current source can be composed of, for example, two transistors 35, 36 connected in a cascode arrangement. The control signal PC is input to one of the gates of these transistors, and a control signal VB is input to the other gate. When the control signal PC becomes high level, the transistor 35 is turned ON, and when the control signal VB becomes high level, the transistor 36 is turned ON. These transistors 35, 36 are used to precharge the first capacitance element 31 and the second capacitance element 32. By precharging the first capacitance element 31 and the second capacitance element 32, noise can be reduced.

As described above, in the present embodiment, the second pixel circuit 17, which is a part of the pixel circuit, is shared by the plurality of pixels 15 and the plurality of first pixel circuits 16. The second pixel circuit 17 includes a second reset transistor 41, a second amplification transistor 43 configuring a second source follower circuit 42, a second selection transistor 44, and a current source 45.

The second reset transistor 41 is arranged between a reference voltage node VREG and the second floating diffusion region FD2. The second reset transistor 41 is turned ON when an RB signal is at a high level, and initializes a charge of the second floating diffusion region FD2.

A gate of the second amplification transistor 43 configuring the second source follower circuit 42 is connected to the second floating diffusion region FD2, a drain to a reference voltage node VDD, and a source to a drain of the second selection transistor 44. The second source follower circuit 42 generates a pixel signal according to the voltage level of the second floating diffusion region FD2 and supplies the pixel signal to the second selection transistor 44.

The second selection transistor 44 is turned ON when an SEL signal is at a high level, and outputs the pixel signal generated by the second source follower circuit 42 to the vertical signal line VSL. The SEL signal is supplied by a row selection lines L1 connected to the vertical drive unit 12 shown in Fig. 1.

Fig. 4 is a circuit diagram showing an example in which four pixels 15 and four first pixel circuits 16 share one second pixel circuit 17. Fig. 4 shows an example in which the second pixel circuit 17 is shared by two pixels 15 in the first direction X (row direction) and two pixels 15 in the second direction Y (vertical direction), that is, a total of four pixels 15.

As shown in Fig. 4, output nodes n2 of the four first pixel circuits 16 are connected to one second floating diffusion region FD2. Accordingly, the second reset transistor 41, the second source follower circuit 42, and the second selection transistor 44 in the second pixel circuit 17 are shared by the four pixels 15 and the four first pixel circuits 16.

The four pixels 15, the four first pixel circuits 16, and the one second pixel circuit 17 shown in Fig. 4 are referred to as unit pixel group regions 40 in the present specification. In the example shown in Fig. 4, the photoelectric conversion element 21, the transfer transistor 22, the first reset transistor 23, the first source follower circuit 24, the first selection transistor 26, the conversion efficiency switching transistor 27, and the discharge transistor 30 that configure a pixel 15 are arranged on the first substrate. Further, the first capacitance element 31, the first sampling transistor 33, the second capacitance element 32, the second sampling transistor 34, and the group of transistors 35, 36 configuring the current source that configure a first pixel circuit 16, , and the second reset transistor 41, the second source follower circuit 42, and the second selection transistor 44 that configure the second pixel circuit 17, are arranged on the second substrate.

Fig. 5 is a cross-sectional view showing a cross-sectional structure of the light detection device 3 according to one embodiment. As described above, the light detection device 3 according to one embodiment has a laminated structure in which three semiconductor substrates (first to third substrates) 51 to 53 are laminated. The first substrate 51 is arranged on the light incident surface side, the second substrate 52 is laminated on the first substrate 51, and the third substrate 53 is laminated on the second substrate 52. The first substrate 51 and the second substrate 52 are joined to each other by metal pads and transmit/receive signals. More specifically, a plurality of first metal pads 63 provided on the first substrate 51 and a plurality of second metal pads 68 provided on the second substrate 52 are joined to each other, and each signal is transmitted and received through these metal pads.

A semiconductor layer (second semiconductor layer) 64 is arranged on the side of the second substrate 52 facing the third substrate 53, and a via hole 70 penetrating the semiconductor layer 64 is provided. This via hole is referred to as a TSV (Through Silicon Via) 70 because it penetrates the second semiconductor layer (specifically, silicon layer) 64. A plurality of third metal pads 71 arranged at an end of the TSV 70 on the third substrate 53 side and a plurality of fourth metal pads 75 of the third substrate 53 are joined, and the second substrate 52 and the third substrate 53 transmit and receive signals via these metal pads 71, 75.

A plurality of pixels 15 are arranged on the first substrate 51. On the second substrate 52, a plurality of first pixel circuits 16 and a plurality of second pixel circuits 17 are arranged. A logic circuit 54 is arranged on the third substrate 53. A peripheral circuit 55 (see Fig. 6) including the vertical drive unit 12, the column signal processing unit 13, and the timing control unit 14 other than the pixel array unit 11 shown in Fig. 2 is arranged in, for example, an empty area of at least one of the first substrate 51 and the second substrate 52, as will be described later. At least a part of the peripheral circuit 55 may be arranged on the third substrate 53.

A first semiconductor layer 56, a first wiring layer 57, a color filter 58, an on-chip lens 59 and the like are arranged on the first substrate 51.

In the first semiconductor layer 56, the photoelectric conversion element 21 is arranged for each pixel 15. The photoelectric conversion element 21 is formed by arranging an n-type semiconductor region in a p-type well region. In a boundary region between pixels 15, a light shielding wall 60 that absorbs light from the adjacent pixel 15 is arranged. A fixed charge film 61 for preventing the generation of a dark current is arranged on the surface of the light shielding wall 60.

A first main surface S1 of the first semiconductor layer 56 is a light incident plane. The first main surface S1 has an uneven structure 62 for anti-reflection. The color filter 58 is arranged on the first main surface S1, and the on-chip lens 59 is arranged thereabove. Note that the color filter 58 and the on-chip lens 59 do not have to be essential constituent members and may be omitted.

On the second main surface S2 of the first semiconductor layer 56, some of the pixel transistors such as the transfer transistor 22 are arranged, and the first wiring layer 57 is arranged thereon (in the lower part of Fig. 5). The first wiring layer 57 has a laminated structure having a plurality of wiring layers and via holes separated by the first insulating layer 50. The plurality of first metal pads 63 are arranged on an end surface of the first wiring layer 57 on the second substrate 52 side.

On the second substrate 52, a second semiconductor layer 64, a second wiring layer 65, a third wiring layer 66, and the like are arranged. The second wiring layer 65 is arranged on the second semiconductor layer 64 on the first main surface S3 side, and the third wiring layer 66 is arranged on a second main surface S4 of the second semiconductor layer 64. The first main surface S3 of the second semiconductor layer 64 is on the first substrate 51 side, and the second main surface S4 is on the third substrate 53 side.

The second wiring layer 65 has a laminated structure having a plurality of wiring layers and via holes separated by a second insulating layer 67. The plurality of second metal pads 68 are arranged on an end surface of the second wiring layer 65 on the first substrate 51 side. The plurality of second metal pads 68 are joined to the corresponding first metal pads 63 respectively, and transmit and receive signals between the first substrate 51 and the second substrate 52. The first metal pads 63 and the second metal pads 68 are provided one by one for each pixel 15, and transmit and receive a voltage signal at the output node n1 of the pixel 15 shown in Fig. 3.

Each of the transistors in the first pixel circuit 16 and second pixel circuit 17 shown in Fig. 3 is arranged on the second semiconductor layer 64. Via holes extending from the second wiring layer 65 are connected to these transistors.

Further, the TSV 70 penetrating the second semiconductor layer 64 and the third wiring layer 66 and extending to the third substrate 53 side is arranged. The TSV 70 is connected to the vertical signal line VSL shown in Fig. 3. The vertical signal line VSL is formed in, for example, the second wiring layer 65 of the second substrate 52. The plurality of third metal pads 71 are arranged at the end of the TSV 70 on the third substrate 53 side.

A third semiconductor layer 72, a fourth wiring layer 73 and the like are arranged on the third substrate 53. The fourth wiring layer 73 is arranged on a first main surface S5 of the third substrate 53, and the third semiconductor layer 72 is arranged on a second main surface S6 of the third substrate 53.

The fourth wiring layer 73 has a laminated structure having a plurality of wiring layers and via holes separated by a third insulating layer 74. The plurality of fourth metal pads 75 are arranged on an end surface of the fourth wiring layer 73 on the second substrate 52 side. The plurality of fourth metal pads 75 are joined to the corresponding third metal pads 71 respectively, and transmit and receive signals between the second substrate 52 and the third substrate 53. The third metal pads 71 and the fourth metal pads 75 are provided as many as the number of vertical signal lines VSL.

Thus, the first substrate 51 and the second substrate 52 are joined by the first metal pad 63 and the second metal pad 68, with the first wiring layer 57 and the second wiring layer 65 arranged in a Face-to-Face fashion (F to F). The second substrate 52 and the third substrate 53 are joined by the third metal pad 71 and the fourth metal pad 75, with the second wiring layer 65 and the fourth wiring layer 73 arranged in a Face -to-Back (F to B) fashion.

As shown in Fig. 5, the cross-sectional structure immediately below the pixel 15 is different from that of the region other than immediately below the pixel 15. In a region other than immediately below the pixel 15, a TSV 76 having a diameter larger than that of the TSV 70 in the pixel region is arranged from the second substrate 52 to the third substrate 53. This TSV 76 is, for example, for obtaining a substrate contact, and is applied with a predetermined reference voltage (e.g., a power supply voltage or a ground voltage).

Although not shown in Fig. 5, a reference contact is provided to supply a reference potential to at least one of the first substrate 51, the second substrate 52, and the third substrate 53. This reference contact is also called a well contact.

Although Fig. 5 does not show a cross-sectional structure of the peripheral circuit of the pixel 15 on the first substrate 51 and the second substrate 52, the peripheral circuit is arranged on, for example, the first substrate 51 or the second substrate 52 immediately above the TSV 76, as will be described later.

The peripheral circuit of the pixel 15 includes the vertical drive unit 12, the column signal processing unit 13 and the like show in Fig. 2, and has a plurality of transistors. Each transistor of the peripheral circuit is arranged in at least one empty area of the first substrate 51, the second substrate 52, or the third substrate 53.

Fig. 6 is a cross-sectional view showing a first example of the cross-sectional structure of the peripheral circuit 55 of the pixel 15. In the first example, the peripheral circuit 55 of the pixel 15 is arranged on the second substrate 52. In this case, since the peripheral circuit 55 does not need to be arranged on the first substrate 51, for example, the number of pixels can be increased instead, and high resolution can be realized. Alternatively, the capacitance of the first capacitance element 31 and the second capacitance element 32 formed on the first substrate 51 can be increased, and the sensitivity can be improved.

Fig. 7 is a cross-sectional view showing a second example of the cross-sectional structure of the peripheral circuit 55 of the pixel 15. In the second example, the peripheral circuit 55 of the pixel 15 is arranged on the first substrate 51 and the second substrate 52 separately. By arranging the peripheral circuits 55 in a dispersed manner on the first to third substrates 51 to 53, element density of each substrate can be made uniform, and noise such as crosstalk can be easily suppressed. Although Fig. 7 does not show the joint structures of the peripheral circuit 55 of the first substrate 51 and the peripheral circuit 55 of the second substrate 52, the joining may be performed by the metal pads described above or by via holes.

Fig. 8 is a plan layout view of 2×2 pixels on the first substrate 51 in a case where four pixels 15 and four first pixel circuits 16 share one second pixel circuit 17. In Fig. 8, the regions of 2×2 pixels on the first substrate 51 and the second substrate 52 are referred to as the unit pixel group regions 40. A plurality of the unit pixel group regions 40 are arranged in a two-dimensional direction on the first substrate 51 and the second substrate 52. The four pixels 15 and the four first pixel circuits 16 sharing the one second pixel circuit 17 may be, for example, a unit pixel group in a Bayer array. In this case, the unit pixel group may be configured by four pixels 15 of red (R), green (G), blue (B), and green (G), or may be configured by four pixels 15 of red (R), green (G), blue (B), and white (W).

The example of the first substrate 51 shown in Fig. 8 includes a unit pixel group region 40 including two pixels in each of the first direction X and the second direction Y. As shown in Fig. 8, a plurality of the unit pixel group regions 40 including four pixels 15 are arranged in a two-dimensional direction on the first substrate 51. The transfer transistor 22, the first reset transistor 23, the first source follower circuit 24, the first selection transistor 26, the discharge transistor 30, and the conversion efficiency switching transistor 27 are arranged in each of the unit pixel group regions 40. The photoelectric conversion element 21 is arranged below these transistors in almost the entire area of each pixel region. More specifically, as shown in Fig. 8, in the unit pixel group regions 40, a gate TRG of the transfer transistor 22, a gate RST of the first reset transistor 23, a gate SF1 of the first source follower circuit 24, a gate SW of the first selection transistor 26, a gate FDG of the conversion efficiency switching transistor 27, and a gate OFG of the discharge transistor 30 are arranged with a diffusion layer 37 interposed therebetween, respectively. The white parts in the respective pixel regions are insulating layers 38.

Fig. 9 is a plan layout view of the unit pixel group region 40 for 2×2 pixels on the second substrate 52 laminated on the first substrate 51 shown in Fig. 8. In the second substrate 52, a plurality of the unit pixel group regions 40 are arranged in a two-dimensional direction. Four first pixel circuits 16 and one second pixel circuit 17 are arranged in each unit pixel group region 40. Further, one TSV 70 is arranged in each unit pixel group region 40.

In the example shown in Fig. 9, within the unit pixel group region 40 for four pixels are arranged a first row in which the group of two transistors 35, 36 constituting a current source are arranged along the first direction X, a second row in which two of a pair of the first sampling transistor 33 and the second sampling transistor 34 are arranged, a third row in which the TSV 70, the second selection transistor 44, the second source follower circuit 42, the second reset transistor 41, and a well contact region WC are arranged, a fourth row in which two of a pair of the first sampling transistor 33 and the second sampling transistor 34 are arranged, and a fifth row in which the group of two transistors 35, 36 constituting the current source are arranged. In each row, the gate and diffusion region of each transistor are arranged along the first direction X.

For example, in the first row and the fifth row, gates VB, PC, PC, VB of the group of two transistors 35, 36 constituting the current source are arranged in this order along the first direction X, with the diffusion layer 37 interposed between the respective gates. In the second row and the fourth row, gates SR, SD, SR, SD of the first and second sampling transistors 33, 34 are arranged in this order along the first direction X, with the diffusion layer 37 interposed between the respective gates. In the third row, the TSV 70, a gate SEL of the second selection transistor 44, a gate SF2 of the second source follower circuit 42, and a gate RB of the second reset transistor 41 are arranged in this order along the first direction X, with the diffusion layer 37 interposed between the respective gates.

In this manner, the respective transistors and the like configuring the four first pixel circuits 16 and the one second pixel circuit 17 are symmetrically arranged on the second substrate 52.

Particularly, in the example shown in Fig. 9, the gate length direction of each transistor is the first direction X, and the diffusion layer 37 is arranged on either side of the gate of each transistor in the first direction X. Thus, the transistors adjacent to each other in the first direction X are arranged with the diffusion layer 37 therebetween, and the risk of channel modulation due to the influence of the adjacent transistors can be avoided.

Also, the TSV 70 connected to the vertical signal line VSL is arranged on one axis (third row) extending in the first direction X, together with the second selection transistor 44, the second source follower circuit 42, and the second reset transistor 41. Thus, the TSV 70 and the second selection transistor 44 being adjacent to each other in the first direction X are arranged with the diffusion layers 37 interposed therebetween, so that the risk of channel modulation of the second selection transistor 44 due to a change in potential of the TSV 70 can be avoided..

Note that the layout view of Fig. 9 is merely an example, and various modifications can be taken. For example, the TSV 70 may be arranged on one axis (second row or fourth row) along with the first sampling transistor 33 and the second sampling transistor 34. Alternatively, the TSV 70 may be arranged on one axis (first row or fifth row) along with the group of transistors 35, 36 constituting the current source.

Further, at least some of the transistors shown in Fig. 9 may be arranged in point symmetry or line symmetry. For example, the gate SF2 of the second source follower circuit 42 may be arranged in the center of the unit pixel group region 40, and the gate SR of the first sampling transistor 33 for four pixels and the gate SD of the second sampling transistor 34 for four pixels may be arranged in point symmetry or line symmetry with respect to the gate SF2. Thus, crosstalk applied to a channel immediately below the gate SF2 of the second source follower circuit 42 by the first sampling transistor 33 and the second sampling transistor 34 of each shared pixel can be made uniform, improving the image quality.

Although Fig. 9 shows an example in which the TSV 70 is arranged near the boundary of the center of the unit pixel group region 40 of 2×2 pixels 15 in the second direction Y, various modifications can be considered for the location where the TSV 70 is arranged. Fig. 10 is a plan layout view of the second substrate 52 according to a first modification of Fig. 9. As shown in Fig. 10, the unit pixel group region 40 of the second substrate 52 according to the first modification includes a TSV 70 arranged at a position different from that shown in Fig. 9. More specifically, the TSV 70 is arranged in the second row of the unit pixel group region 40. In the second row, the TSV 70, the second sampling transistor 34, the first sampling transistor 33, the second sampling transistor 34, and the first sampling transistor 33 are arranged in this order on one axis along the first direction X.

The channel immediately below the gate of each transistor in the second row extends in the first direction X, and the diffusion layers 37 are arranged on both sides of each channel in the first direction X. Therefore, the diffusion layer 37 of the second sampling transistor 34 is arranged between the TSV 70 and the second sampling transistor 34 adjacent thereto, and the TSV 70 can be prevented from being modulated by the gate of the second sampling transistor 34.

Fig. 11 is a plan layout view of the second substrate 52 according to a second modification of Fig. 9. As shown in Fig. 11, the unit pixel group region 40 of the second substrate 52 according to the second modification includes a TSV 70 arranged at a location different from those shown in Figs. 9 and 10. More specifically, the TSV 70 is arranged in the first row of the unit pixel group region 40. In the first row, the TSV 70, the group of two transistors 35, 36 constituting a current source, and the group of two transistors 35, 36 constituting a current source are arranged in this order along the first direction X.

Fig. 12 is a diagram schematically showing a cross-sectional structure around the TSV 70. As shown, a channel 85 is arranged immediately below a gate 84 of a transistor. As described above, the TSV 70 is connected to the vertical signal line VSL and transmits a pixel signal of each pixel 15. Therefore, the signal level of the TSV 70 fluctuates frequently. If the TSV 70 is located near a transistor, the potential of the channel 85 of said transistor may be modulated by a pixel signal transmitted by the TSV 70. As shown in Fig. 12, if a diffusion layer 86 of a transistor is arranged between the TSV 70 and a transistor, the potential of the channel 85 of the transistor is less likely to be modulated by a signal change of the TSV 70.

Although Fig. 4 shows an example in which four pixels 15 and four first pixels 15 share one second pixel circuit 17, the unit of pixel sharing is not limited to four. For example, one second pixel circuit 17 may be shared by one pixel in the first direction X (e.g., the horizontal direction) and two pixels in the second direction Y (e.g., the vertical direction) as the unit pixel group region 40.

Fig. 13 is a circuit diagram where two pixels 15 and two first pixel circuits 16 share one second pixel circuit 17 using pixels 15, the first pixel circuit 16, and the second pixel circuit 17 of the circuit configuration shown in Fig. 3. As shown in Fig. 13, two pixels 15 and two first pixel circuits 16 arranged in the second direction Y are to be shared, and these two first pixel circuits 16 and one second pixel circuit 17 share the second floating diffusion region FD2. Fig. 13 shows a circuit configuration for four pixels, in which two upper and lower first pixel circuits 16 on the left side are connected to one second pixel circuit 17, and two upper and lower first pixel circuits 16 on the right side are connected to another second pixel circuit 17.

As shown in Fig. 13, the layout arrangement in the first layer in a case where two pixels 15 and two first pixel circuits 16 share one second pixel circuit 17 is similar to that shown in Fig. 8.

Fig. 14 is a plan layout view of a region in which two unit pixel group regions 40 for 1×2 pixels are arranged on the second substrate 52 composed of the pixel 15 and pixel circuits shown in Fig. 31. Since one TSV 70 is arranged for two pixels 15, the TSV 70 is arranged at the center of each side of the region where two unit pixel group regions 40 for 1×2 pixels are arranged.

Five rows (first to fifth rows) are arranged in the region where two unit pixel group regions 40 shown in Fig. 14 are arranged. In the first row and the fifth row, the gates VB, PC constituting the group of transistors 35, 36 configuring the current source, the gate RB of the second reset transistor 41, the gates PC, VB constituting the group of transistors 35, 36 configuring the current source are arranged in this order along the first direction X. In the second row and the fourth row, the gate SR of the first sampling transistor 33, the gate SD of the second sampling transistor 34, the well contact region WC, the gate SD of the second sampling transistor 34, and the gate SR of the first sampling transistor 33 are arranged in this order along the first direction X. In the third row, the TSV 70, the gate SEL of the second selection transistor 44, the gate SF2 of the second source follower circuit 42, the gate SF2 of the second source follower circuit 42, and the gate SEL of the second selection transistor 44 are arranged in this order along the first direction X.

Since the diffusion layer 37 of the second selection transistor 44 is arranged between the TSV 70 of the third row and the gate SEL of the second selection transistor 44 adjacent thereto, the channel under the gate SEL of the second selection transistor 44 is not modulated by the signal change of the TSV 70.

Two second pixel circuits 17 and two TSVs 70 are provided in the region where two unit pixel group regions 40 are arranged in Fig. 14. Although the TSV 70 is connected to the source of the second selection transistor 44, the distance between the TSV 70 and the source of the second selection transistor 44 is not the same, as shown in Fig. 15. For this reason, there is a risk that the wiring load and parasitic capacitance of the wiring connecting the source of the second selection transistor 44 and the TSV 70 may fluctuate, resulting in a decrease in image quality.

Fig. 16 is a plan layout view showing a measure for suppressing fluctuations in the wiring load and parasitic capacitance of the wiring connected to the TSV 70. Fig. 16 is a plan layout view showing a layout arrangement in which two unit pixel group regions 40 for 1×2 pixels 15 are arranged in the first direction X (e.g., horizontal direction) and shifted by a half pitch in the second direction Y (e.g., vertical direction). Each of the two frames in Fig. 16 shows the unit pixel group regions 40. The TSV 70 is arranged at the top right corner of the unit pixel group region 40 on the left-hand side in Fig. 16, and this top is positioned at the center of the left side of the unit pixel group region 40 on the right-hand side. Further, the TSV 70 is arranged at the center of the left side of the unit pixel group region 40 on the left-hand side. Thus, the left unit pixel group region 40 and the right unit pixel group region 40 are arranged with a half pitch shift.

Thus, the source of the second selection transistor 44 is arranged laterally to the right of the TSV 70 at the center of the left side of the unit pixel group region 40 on the left-hand side, and the source of the second selection transistor 44 is arranged laterally to the right of the TSV 70 at the center of the left side of the unit pixel group region 40 on the right-hand side, whereby the wiring load and parasitic capacitance of the wiring connecting the source of the second selection transistor 44 and the TSV 70 can be prevented from fluctuating.

Although an example in which the second pixel circuit 17 is shared by the two pixels 15 or the four pixels 15 has been described above, a layout arrangement in which the second pixel circuit 17 is not shared by pixels may be adopted.

Fig. 17 is a plan layout view of the non-pixel shared second substrate 52, showing a pixel region for one pixel. In the pixel region of Fig. 17, three rows (first to third rows) are arranged. In the first row, the gates VB, PC of the group of transistors 35, 36 configuring the current source are arranged in this order along the first direction X. In the second row, the TSV 70, the gate SEL of the second selection transistor 44, and the gate SF2 of the second source follower circuit 42 are arranged in this order along the first direction X. In the third row, the gate RB of the second reset transistor 41, the gate SR of the first sampling transistor 33, and the gate SD of the second sampling transistor 34 are arranged in this order along the first direction X.

In Fig. 17 as well, since the diffusion layer 37 of the second selection transistor 44 is arranged between the TSV 70 and the second selection transistor 44, there is no risk that the channel under the gate SEL of the second selection transistor 44 is modulated by a signal change of the TSV 70.

Fig. 18 is a plan layout view showing an example of a joint location of the first metal pad 63 and the second metal pad 68 and an arrangement location of the TSV 70 on the second substrate 52. While the first metal pad 63 and the second pad are provided for each pixel 15, one TSV 70 is provided for each unit pixel group region 40 composed of a plurality of (e.g., four) pixels 15. Therefore, as shown in Fig. 18, for example, it is conceivable to arrange the joint location between the first metal pad 63 and the second metal pad 68 at the center of each pixel region, and to arrange the TSV 70 at the center of the boundary side of the unit pixel group region 40 in the first direction X. Fig. 18 is an example of the arrangement locations and sizes of the first metal pad 63, the second metal pad 68, and the TSV 70, and can take various modifications.

The specific circuit configuration of the pixel 15 and the pixel circuit is not limited to the circuit configuration shown in Fig. 3 or Fig. 15, and various circuit configurations can be applied.

The specific circuit configuration of the pixel 15 and the pixel circuit is not limited to the circuit configuration shown in Fig. 3 or Fig. 15, and various circuit configurations can be applied.

Fig. 19 is a circuit diagram of the pixel 15, the first pixel circuit 16, and the second pixel circuit 17 according to a first modification. Fig. 19 differs from Figs. 3 and 15 in the circuit configuration of the first pixel circuit 16. Although Fig. 19 omits the discharge transistor 30 and the conversion efficiency switching transistor 27 in the pixel 15, these transistors may be provided, and the configuration of the pixel 15 is substantially the same as that shown in Fig. 3.

The first pixel circuit 16 shown in Fig. 19 has the first capacitance element 31, the second capacitance element 32, the first sampling transistor 33, the second sampling transistor 34, the group of transistors 35, 36 constituting a current source, and a sample-and-hold transistor 83.

The sample-and-hold transistor 83 is connected between an output node n1 of the pixel 15 and an output node n2 of the first pixel circuit 16. The first capacitance element 31 and the first sampling transistor 33 are connected in series between a reference voltage node (e.g., a power supply voltage node) and the output node n2 of the first pixel circuit 16. The second capacitance element 32 and the second sampling transistor 34 are connected in series between the reference voltage node and the output node n2 of the first pixel circuit 16.

Fig. 20 is a circuit diagram of the pixel 15, the first pixel circuit 16, and the second pixel circuit 17 according to a second modification. Fig. 20 has the pixel 15 of substantially the same circuit configuration as that shown in Fig. 3 and the first pixel circuit 16 of a circuit configuration different from that shown in Fig. 3.

The first pixel circuit 16 shown in Fig. 20 has a first output node and SF21 and a second output node SF22, to which the second pixel circuit 17 is connected separately. With one transistor, not shown, being added separately and only one second pixel circuit 17 being taken, the first output node SF21 or the second output node SF22 may be selected with the added transistor and connected to the second pixel circuit 17. One second pixel circuit 17 has a second source follower circuit 42R and a second selection transistor 44R, and the other second pixel circuit 17 has a second source follower circuit 42D and a second selection transistor 44D.

The first pixel circuit 16 shown in Fig. 20 has a transistor connected to the output node n1 of the pixel 15 and constituting a current source, the first sampling transistor 33, the first capacitance element 31, the second sampling transistor 34, and the second capacitance element 32. The first capacitance element 31 is connected between the reference voltage node and the first output node SF21. The first sampling transistor 33 is connected between the first output node SF21 and the output node n1 of the pixel 15. The second capacitance element 32 is connected between the reference voltage node and the second output node SF22. The second sampling transistor 34 is connected between the second output node SF22 and the output node n1 of the pixel 15.

Fig. 21 is a circuit diagram of the pixel 15, the first pixel circuit 16, and the second pixel circuit 17 according to a third modification. Fig. 21 has the pixel 15 of substantially the same circuit configuration as that shown in Fig. 3 and the first pixel circuit 16 of a circuit configuration different from that shown in Fig. 3.

The first pixel circuit 16 shown in Fig. 21 has the first and second sampling transistors 33 and 34, the first capacitance element 31, the second capacitance element 32, and the group of transistors 35, 36 constituting a current source.

The first sampling transistor 33 and the second capacitance element 32 are connected in series between the output node n1 of the pixel 15 and the output node n2 of the first pixel circuit 16. The first capacitance element 31 is connected between a reference voltage node (e.g., a power supply voltage node) and the output node n2 of the first pixel circuit 16. The second sampling transistor 34 is connected between the reference voltage node and the output node n2 of the first pixel circuit 16.

Fig. 22 is a circuit diagram of the pixel 15, the first pixel circuit 16, and the second pixel circuit 17 according to a fourth modification. Fig. 22 has the pixel 15 of substantially the same circuit configuration as that shown in Fig. 3 and the first pixel circuit 16 and the second pixel circuit 17 of a circuit configuration different from that shown in Fig. 3.

The first pixel circuit 16 shown in Fig. 22 includes the transistor 35 constituting a current source that is connected between the output node n1 of the pixel 15 and the reference voltage node (e.g., ground node), the first sampling transistor 33 and the second sampling transistor 34 that are connected in a cascode arrangement between the output node n1 of the pixel 15 and the output node n2 of the first pixel circuit 16, the first capacitance element 31 connected between a connection node of the first sampling transistor 33 and the second sampling transistor 34 and the reference voltage node (e.g., ground node), and the second capacitance element 32 connected between the output node n2 of the first pixel circuit 16 and the reference voltage node (e.g., ground node).

The second pixel circuit 17 shown in Fig. 22 includes the second source follower circuit 42 (second amplification transistor 43) and the second selection transistor 44 that are connected in a cascode arrangement between a reference voltage node (e.g., power supply voltage node) and the vertical signal line VSL. Although the second pixel circuit 17 shown in Fig. 23 does not have the second sampling transistor 34 shown in Fig. 3, the second sampling transistor 34 may be added.

Fig. 23 is a circuit diagram of the pixel 15, the first pixel circuit 16, and the second pixel circuit 17 according to a fifth modification. Fig. 22 has the pixel 15 of substantially the same circuit configuration as that shown in Fig. 3 and the first pixel circuit 16 of a circuit configuration different from that shown in Fig. 3.

The first pixel circuit 16 shown in Fig. 23 has the transistor 35 constituting a current source that is connected between the output node n1 of the pixel 15 and the reference voltage node (e.g., ground node), the first capacitance element 31 connected between the output node n1 of the pixel 15 and the output node n2 of the first pixel circuit 16, and the second capacitance element 32 connected between the output node n2 of the first pixel circuit 16 and the reference voltage node (e.g., ground node).

Although the first pixel circuit 16 shown in Fig. 3 and according to the first to fifth modifications described above has the current source connected between the output node n1 of the pixel 15 and the reference voltage node (e.g., ground node), the current source may be composed of the group of transistors 35, 36 or may be composed of a single transistor 35. Further, whether or not to provide the conversion efficiency switching transistor 27 and the discharge transistor 30 in the pixel 15 may be option.

Thus, in the present embodiment, since the global shutter type light detection device 3 for converting a photo-electrically converted charge into a voltage signal and holding it is formed into a laminated structure of the first to third substrates 51 to 53, the arrangement region of the pixels 15 is not compressed, and high resolution can be achieved. Furthermore, the first capacitance elements 31 and the second capacitance element 32 having sufficient capacitance for holding the voltage signal can be secured, and the dynamic range can be expanded.

In addition, since the first substrate 51 and the second substrate 52 perform signal transmission by joining the metal pads to each other, and the second substrate 52 and the third substrate 53 perform signal transmission by joining the metal pads arranged at the end of the TSV 70 penetrating the semiconductor layer on the second substrate 52, signal transmission can be efficiently performed between the respective substrates. A laminated chip can be reduced in size. In particular, in the present embodiment, since the diffusion layer 37 of the transistor in the vicinity of the TSV 70 is arranged between the TSV 70 and said transistor, the risk that a signal change of the TSV 70 modulates the channel of said nearby transistor can be eliminated, and the operation of the pixel circuit can be stabilized, improving the image quality.

<Examples of application to mobile object> The technique of the present disclosure (the present technique) can be applied to various products. For example, the technique according to the present disclosure may be implemented as a device equipped in any type of mobile object such as an automobile, an electric vehicle, a hybrid electric vehicle, a motorcycle, a bicycle, a personal mobility device, an airplane, a drone, a ship, and a robot.

Fig. 24 is a block diagram showing a schematic configuration example of a vehicle control system that is an example of a mobile object control system to which the technique according to the present disclosure can be applied.

A vehicle control system 12000 includes a plurality of electronic control units connected to each other over a communication network 12001. In the example shown in Fig. 24, the vehicle control system 12000 includes a drive system control unit 12010, a body system control unit 12020, a vehicle exterior information detection unit 12030, a vehicle interior information detection unit 12040, and an integrated control unit 12050. A microcomputer 12051, an audio/image output unit 12052, and an in-vehicle network interface (I/F) 12053 are shown as functional configurations of the integrated control unit 12050.

The drive system control unit 12010 controls the operations of a device related to a vehicle drive system according to various programs. For example, the drive system control unit 12010 functions as a control device for controlling a driving force generation device for generating a driving force of a vehicle such as an internal combustion engine or a driving motor, a driving force transmission mechanism for transmitting a driving force to wheels, a steering mechanism for adjusting a turning angle of a vehicle, and a control device such as a braking device that generates a braking force of a vehicle..

The body system control unit 12020 controls the operations of various devices mounted in the vehicle body according to various programs. For example, the body system control unit 12020 functions as a control device for a keyless entry system, a smart key system, a power window device, or various lamps such as a headlamp, a back lamp, a brake lamp, a turn signal, and a fog lamp. In this case, the body system control unit 12020 may receive input of radio waves transmitted from a portable device that substitutes for a key or signals of various switches. The body system control unit 12020 receives input of the radio waves or signals and controls a door lock device, a power window device, and lamps of the vehicle.

The vehicle exterior information detection unit 12030 detects information on the outside of the vehicle having the vehicle control system 12000 mounted thereon. For example, an imaging unit 12031 is connected to the vehicle exterior information detection unit 12030. The vehicle exterior information detection unit 12030 causes the imaging unit 12031 to capture an image outside of the vehicle and receives the captured image. The vehicle exterior information detection unit 12030 may perform object detection processing or distance detection processing for, for example, people, cars, obstacles, signs, and letters on the road based on the received image.

The imaging unit 12031 is an optical sensor that receives light and outputs an electrical signal according to the amount of the received light. The imaging unit 12031 can also output the electrical signal as an image or distance measurement information. Furthermore, the light received by the imaging unit 12031 may be visible light or invisible light such as infrared light.

The vehicle interior information detection unit 12040 detects information on the inside of the vehicle. For example, a driver state detection unit 12041 that detects a state of a driver is connected to the vehicle interior information detection unit 12040. The driver state detection unit 12041 includes, for example, a camera that captures an image of the driver, and the vehicle interior information detection unit 12040 may calculate a degree of fatigue or a degree of concentration of the driver or may determine whether the driver dozes off or not, on the basis of detection information input from the driver state detection unit 12041.

The microcomputer 12051 can calculate a control target value of the driving force generation device, the steering mechanism, or the braking device on the basis of the information on the outside or the inside of the vehicle acquired by the vehicle exterior information detection unit 12030 or the vehicle interior information detection unit 12040, and output a control command to the drive system control unit 12010. For example, the microcomputer 12051 can perform cooperative control for the purpose of implementing functions of an Advanced Driver Assistance System (ADAS) including collision avoidance or impact mitigation of the vehicle, following traveling based on an inter-vehicle distance, vehicle speed maintenance driving, vehicle collision warning, vehicle lane deviation warning, or the like.

Furthermore, the microcomputer 12051 can perform cooperative control for the purpose of automated driving or the like in which autonomous traveling is performed without depending on operations by the driver, by controlling the driving force generation device, the steering mechanism, or the braking device or the like on the basis of information about the surroundings of the vehicle, the information being acquired by the vehicle exterior information detection unit 12030 or the vehicle interior information detection unit 12040.

In addition, the microcomputer 12051 can output a control command to the body system control unit 12030 on the basis of the information outside of the vehicle acquired by the vehicle exterior information detection unit 12030. For example, the microcomputer 12051 can perform cooperative control for the purpose of preventing glare, such as switching from a high beam to a low beam, by controlling the headlamp according to the position of a vehicle ahead or an oncoming vehicle detected by the vehicle exterior information detection unit 12030.

The audio/image output unit 12052 transmits an output signal of at least one of sound and an image to an output device capable of visually or audibly sending information to a passenger of the vehicle or the outside of the vehicle. In the example shown in Fig. 24, an audio speaker 12061, a display unit 12062, and an instrument panel 12063 are shown as output devices. The display unit 12062 may include at least one of an on-board display and a head-up display, for example.

Fig. 25 is a diagram showing an example of a position at which the imaging unit 12031 is installed.

In Fig. 25, the imaging units 12031 include imaging units 12101, 12102, 12103, 12104, and 12105.

The imaging units 12101, 12102, 12103, 12104, and 12105 are provided at, for example, positions of a front nose, side mirrors, a rear bumper, a back door, an upper portion of a vehicle interior front windshield inside of the vehicle, and the like of the vehicle 12100. The imaging unit 12101 provided at the front nose and the imaging unit 12105 provided in the upper portion of the vehicle interior front windshield mainly acquire images in front of the vehicle 12100. The imaging units 12102, 12103 provided at the side mirrors mainly acquire images on the lateral sides of the vehicle 12100. The imaging unit 12104 provided at the rear bumper or the back door mainly acquires rear view images of the back of the vehicle 12100. The imaging unit 12105 provided at the upper portion of the vehicle interior front windshield is mainly used for detecting a vehicle ahead, pedestrians, obstacles, traffic signals, traffic signs, lanes or the like.

Fig. 25 shows an example of the ranges of imaging by the imaging units 12101 to 12104. An imaging range 12111 indicates a range of imaging by the imaging unit 12101 provided at the front nose, imaging ranges 12112, 12113 respectively indicate ranges of imaging by the imaging units 12102, 12103 provided at the side mirrors, and an imaging range 12114 indicates a range of imaging by the imaging unit 12104 provided at the rear bumper or the back door. For example, by superimposing image data captured by the imaging units 12101 to 12104, a bird's-eye view image viewing the vehicle 12100 from above can be obtained.

At least one of the imaging units 12101 to 12104 may have a function for acquiring distance information. For example, at least one of the imaging units 12101 to 12104 may be a stereo camera constituted by a plurality of imaging elements or may be an imaging element that has pixels for phase difference detection.

For example, the microcomputer 12051 can extract, particularly, the closest three-dimensional object that is on a traveling path of the vehicle 12100 and that travels at a predetermined speed (e.g., 0 km/h or higher) in the substantially same direction as that of the vehicle 12100, as a preceding vehicle, by obtaining a distance to each of three-dimensional objects in the imaging ranges 12111 to 12114 and a temporal change of this distance (a relative speed with respect to the vehicle 12100) on the basis of the distance information obtained from the imaging units 12101 to 12104. Furthermore, the microcomputer 12051 can set an inter-vehicle distance that needs to be secured in advance in front of the preceding vehicle and can perform automated brake control (also including following stop control) or automated acceleration control (also including following start control). Thus, cooperative control can be performed for the purpose of, for example, automated driving in which autonomous travel is performed without depending on operations by the driver.

For example, the microcomputer 12051 can classify and extract three-dimensional data regarding three-dimensional objects into two-wheeled vehicles, normal vehicles, large vehicles, pedestrians, and other three-dimensional objects such as electric poles on the basis of distance information obtained from the imaging units 12101 to 12104, and can use the three-dimensional data to perform automated avoidance of obstacles. For example, the microcomputer 12051 differentiates obstacles around the vehicle 12100 as obstacles that can be visually recognized by the driver of the vehicle 12100 and obstacles that are difficult to visually recognize. Furthermore, the microcomputer 12051 determines a collision risk indicating the degree of risk of collision with each obstacle, and when the collision risk is a set value or more and there is a possibility of collision, outputs an alarm to the driver through the audio speaker 12061 or the display unit 12062, or performs forced deceleration or avoidance steering through the drive system control unit 12010, so that it is possible to perform driving support for collision avoidance.

At least one of the imaging units 12101 to 12104 may be an infrared camera that detects infrared rays. For example, the microcomputer 12051 can recognize a pedestrian by determining whether or not there is a pedestrian in the captured images of the imaging units 12101 to 12104. Such pedestrian recognition is performed by, for example, a procedure of extracting feature points in the captured images of the imaging units 12101 to 12104 that are infrared cameras, and a procedure of performing pattern matching processing on a series of feature points indicating an outline of an object and determining whether or not the object is a pedestrian. When the microcomputer 12051 determines that there is a pedestrian in the captured images of the imaging units 12101 to 12104 and recognizes the pedestrian, the audio/image output unit 12052 controls the display unit 12062 so as to superimpose and display a square contour line for emphasis on the recognized pedestrian. Furthermore, the audio/image output unit 12052 may control the display unit 12062 so as to display an icon indicating a pedestrian or the like at a desired position.

An example of a vehicle control system to which the technique according to the present disclosure can be applied has been described above. The technique according to the present disclosure can be applied to, for example, the imaging unit 12031 and the like among the configurations described above. Specifically, the light detection device 3 according to the present embodiment can be applied to the imaging unit 12031." etc.). By applying the technique according to the present disclosure to the imaging unit 12031, a clearer captured image can be obtained, and thus it is possible to reduce the driver's fatigue.

<Examples of application to endoscopic surgery system> The technique according to the present disclosure (the present technique) can be applied to various products. For example, the technique according to the present disclosure may be applied in an endoscopic surgery system.

Fig. 26 illustrates an example of a schematic configuration of an endoscopic surgery system to which the technique according to the present disclosure (the present technique) is applied.

Fig. 26 shows a state where an operator (doctor) 11131 is performing surgery on a patient 11132 on a patient bed 11133 by using an endoscopic surgery system 11000. As illustrated, the endoscopic surgery system 11000 includes an endoscope 11100, other surgical instruments 11110 such as a pneumoperitoneum tube 11111 and an energy treatment tool 11112, a support arm device 11120 that supports the endoscope 11100, and a cart 11200 equipped with various devices for endoscopic surgery.

The endoscope 11100 is composed of a lens barrel 11101 in which a region of a predetermined length from a distal end thereof is inserted into a body cavity of the patient 11132, and a camera head 11102 connected to a base end of the lens barrel 11101. In the illustrated example, the endoscope 11100 is configured as a so-called rigid endoscope having the rigid lens barrel 11101, but the endoscope 11100 may be configured as a so-called flexible endoscope having a flexible lens barrel.

The distal end of the lens barrel 11101 is provided with an opening to which an objective lens is fit. A light source device 11203 is connected to the endoscope 11100, and light generated by the light source device 11203 is guided to the distal end of the lens barrel 11101 by a light guide extending inside of the lens barrel 11101, and is then projected to an observation target in the body cavity of the patient 11132 through the objective lens. The endoscope 11100 may be a direct-view endoscope, an oblique-view endoscope, or a side-view endoscope.

An optical system and an imaging element are provided inside the camera head 11102, and reflected light (observation light) from the observation target is collected on the imaging element by the optical system. The imaging element photoelectrically converts the observation light, and an electrical signal corresponding to the observation light, that is, an image signal corresponding to an observation image, is thus generated. The image signal is transmitted to a camera control unit (CCU) 11201 as RAW data.

The CCU 11201 is configured as a central processing unit (CPU), a graphics processing unit (GPU), or the like, and comprehensively controls the operations of the endoscope 11100 and a display device 11202. In addition, the CCU 11201 receives the image signal from the camera head 11102 and performs various types of image processing for displaying an image that is based on the image signal, such as development processing (demosaic processing), on the image signal.

The display device 11202 displays the image based on the image signal subjected to the image processing by the CCU 11201, under the control of the CCU 11201.

The light source device 11203 includes a light source such as a light-emitting diode (LED) and supplies the endoscope 11100 with irradiating light when an image of a surgical site or the like is to be captured.

An input device 11204 is an input interface for the endoscopic surgery system 11000. A user can input various types of information or instructions to the endoscopic surgery system 11000 via the input device 11204. For example, the user inputs instructions such as an instruction for changing imaging conditions (e.g., a type of irradiating light, a magnification, a focal length, etc.) of the endoscope 11100.

A treatment tool control device 11205 controls driving of the energy treatment tool 11112 for cauterizing or incising a tissue, or sealing a blood vessel. A pneumoperitoneum device 11206 feeds gas into the body cavity of the patient 11132 via the pneumoperitoneum tube 11111 in order to inflate the body cavity for the purpose of securing a field of view through the endoscope 11100 and a working space of the operator. A recorder 11207 is a device capable of recording various types of information pertaining to the surgery. A printer 11208 is a device capable of printing various types of information pertaining to the surgery in various formats such as texts, images, and graphs.

The light source device 11203 that supplies the endoscope 11100 with irradiating light for capturing an image of the surgical site may be configured as a white light source configured as an LED, a laser light source, or a combination thereof, for example. When a white light source is configured as a combination of RGB laser light sources, because the output intensity and the output timing can be controlled for each color (each wavelength) with high accuracy, the light source device 11203 can adjust the white balance of the image to be captured. In this case, by irradiating an observation target with the laser light from the RGB laser light sources by time division and controlling driving of the imaging elements of the camera head 11102 in synchronization with this irradiation timing, images corresponding to RGB can be captured by time division. With this method, color images can be obtained even without providing a color filter to the imaging element.

Furthermore, driving of the light source device 11203 may be controlled such that the intensity of light to be output is changed at predetermined time intervals. By controlling the driving of the imaging element of the camera head 11102 in synchronization with the timing at which the intensity of the light is changed, and acquiring images by time division and combining the resultant images, an image having a high dynamic range can be generated without any so-called black clipping or white clipping.

The light source device 11203 may have a configuration enabled to supply light in a predetermined wavelength band corresponding to a special light observation. In the special light observation, for example, by taking advantage of the wavelength dependency of the light absorbed by a body tissue and emitting light in a band narrower than that of the irradiating light during normal observation (that is, white light), so-called narrow band light observation (narrow band imaging), in which a high-contrast image of a predetermined tissue such as a blood vessel in the superficial layer of a mucous membrane is captured, is performed. Alternatively, in the special light observation, fluorescence observation may be performed to obtain an image by fluorescence generated by emitting excitation light. The fluorescence observation can be performed by irradiating a body tissue with the excitation light and observing fluorescence from the body tissue (autofluorescence observation), or locally injecting a reagent such as indocyanine green (ICG) to a body tissue and irradiating the body tissue with the excitation light corresponding to a fluorescence wavelength of the reagent to obtain a fluorescence image. The light source device 11203 can be configured to be able to supply narrow band light and/or excitation light corresponding to such special light observations.

Fig. 27 is a block diagram showing an example of the functional configurations of the camera head 11102 and the CCU 11201 shown in Fig. 26.

The camera head 11102 includes a lens unit 11401, an imaging unit 11402, a drive unit 11403, a communication unit 11404, and a camera head control unit 11405. The CCU 11201 includes a communication unit 11411, an image processing unit 11412, and a control unit 11413. The camera head 11102 and the CCU 11201 are communicatively connected to each other via a transmission cable 11400.

The lens unit 11401 is an optical system provided to a connection part with the lens barrel 11101. The observation light collected from the distal end of the lens barrel 11101 is guided to the camera head 11102 and becomes incident on the lens unit 11401. The lens unit 11401 is configured as a combination of a plurality of lenses including a zoom lens and a focus lens.

The imaging element configuring the imaging unit 11402 may be a single imaging element (so-called single-board type) or a plurality of imaging elements (so-called multi-board type). In a case where the imaging unit 11402 is of the multi-board type, for example, image signals corresponding to respective RGB may be generated by the respective imaging elements and synthesized to obtain a color image. Alternatively, the imaging unit 11402 may include a pair of imaging elements for acquiring right-eye and left-eye image signals for three-dimensional (3D) rendering. With 3D rendering, the operator 11131 can more accurately recognize the depth of a living tissue in a surgical site. When the imaging unit 11402 is configured as a multi-board type, a plurality of systems of lens units 11401 may also be provided correspondingly to the respective imaging elements.

The imaging unit 11402 does not always need to be provided in the camera head 11102. For example, the imaging unit 11402 may be provided immediately behind the objective lens inside of the lens barrel 11101.

The drive unit 11403 includes an actuator, and the zoom lens and the focus lens of the lens unit 11401 are moved by a predetermined distance along an optical axis under the control of the camera head control unit 11405. The magnification and focus of the image captured by the imaging unit 11402 can therefore be adjusted appropriately.

The communication unit 11404 is configured as a communication device for exchanging various types of information with the CCU 11201. The communication unit 11404 transmits an image signal obtained from the imaging unit 11402 as RAW data to the CCU 11201 over the transmission cable 11400.

The communication unit 11404 receives a control signal for controlling driving of the camera head 11102 from the CCU 11201, and supplies the control signal to the camera head control unit 11405. The control signal includes, for example, information regarding imaging conditions, such as information indicating a designation of a frame rate at which an image is captured, information indicating a designation of an exposure value at the time of imaging, and/or information indicating a designation of the magnification and focal point by which the image is captured.

The imaging conditions, such as the above-mentioned frame rate, exposure value, magnification, and focal point, may be designated by the user as appropriate, or may be automatically set by the control unit 11413 of the CCU 11201 on the basis of the acquired image signal. In the latter case, the endoscope 11100 is equipped with a so-called auto-exposure (AE) function, auto-focus (AF) function, and auto-white balance (AWB) function.

The camera head control unit 11405 controls the driving of the camera head 11102 on the basis of a control signal from the CCU 11201 received via the communication unit 11404.

The communication unit 11411 is configured as a communication device for exchanging various types of information with the camera head 11102. The communication unit 11411 receives an image signal transmitted via the transmission cable 11400 from the camera head 11102.

The communication unit 11411 transmits the control signal for controlling the driving of the camera head 11102, to the camera head 11102. The image signal or the control signal can be transmitted through electric communications, optical communications, or the like.

The image processing unit 11412 performs various types of image processing on the image signal that is the RAW data transmitted from the camera head 11102.

The control unit 11413 performs various types of control for causing the endoscope 11100 to capture an image of a surgical site or the like, and for displaying the captured image obtained by capturing an image of the surgical site or the like. For example, the control unit 11413 generates a control signal for controlling the driving of the camera head 11102.

The control unit 11413 also causes the display device 11202 to display the captured image showing the surgical site or the like, on the basis of the image signal that has been subjected to the image processing performed by the image processing unit 11412. At this point, the control unit 11413 may recognize various objects in the captured image using various image recognition techniques. For example, the control unit 11413 can recognize a surgical instrument such as forceps, a specific biological region, bleeding, mist or the like during the use of the energy treatment tool 11112, or the like by detecting the shape of an edge of the object included in the captured image, a color, and the like of the same. When causing the display device 11202 to display the captured image, the control unit 11413 may superimpose various types of surgery support information on the image of the surgical site for display using a result of the recognition. The surgery support information is superimposed for display and is presented to the operator 11131, so that a burden on the operator 11131 can be reduced and the operator 11131 can reliably perform surgery.

The transmission cable 11400 that connects the camera head 11102 and the CCU 11201 is an electrical signal cable that supports communication of electrical signals, an optical fiber that supports optical communication, or a composite cable thereof.

Although wired communication is performed using the transmission cable 11400 in the illustrated example, radio communications may be performed between the camera head 11102 and the CCU 11201.

An example of the endoscopic surgery system to which the technique according to the present disclosure can be applied has been described above. Of the configurations described above, the technique according to the present disclosure can be applied to, for example, the endoscope 11100, (the imaging unit 11402 of) the camera head 11102, (the image processing unit 11412 of) the CCU 11201, and the like. Specifically, the light detection device 3 according to the present embodiment can be applied to the imaging unit 10402. By applying the technique according to the present disclosure to the imaging unit 10402, it is possible to obtain a clearer image of a surgical site, and thus, the operator can reliably confirm the surgical site.

Here, although an endoscopic surgery system has been described as an example, the technique according to the present disclosure may be applied to other systems such as a microscopic surgery system.

The present technique may have the following configurations.

(1) A light detection device, comprising:
   a plurality of pixels, each of which accumulates a charge corresponding to an amount of incident light;
   a plurality of first pixel circuits that have a plurality of capacitance elements that retain, at the same timing, voltage signals corresponding to charges accumulated in the plurality of pixels;
   a plurality of second pixel circuits that generate pixel signals corresponding to charges retained by the plurality of capacitance elements;
   a logic circuit that performs signal processing on the plurality of pixel signals generated by the plurality of second pixel circuits;
   a first substrate on which the plurality of pixels are arranged;
   a second substrate that is laminated on the first substrate and on which the plurality of first pixel circuits and the plurality of second pixel circuits are arranged; and
   a third substrate that is laminated on the second substrate and on which the logic circuit is arranged, wherein
   the first substrate includes a plurality of first metal pads that are arranged opposite the second substrate and to which output nodes of the plurality of pixels are connected,
   the second substrate includes:
      a semiconductor layer arranged opposite the third substrate;
      a plurality of second metal pads joined to the plurality of first metal pads;
      a plurality of first via holes arranged to penetrate the semiconductor layer from the plurality of second pixel circuit; and
      a plurality of third metal pads arranged opposite the third substrate and connected to the plurality of first via holes, and
      the third substrate includes a plurality of fourth metal pads joined to the plurality of third metal pads,
      each of the plurality of first via holes is provided to correspond to one or more of the first pixel circuits and one or more of the second pixel circuits, and
      each of the plurality of first via holes and at least one transistor in the one or more of the first pixel circuits to which each of the plurality of first via holes correspond, or the one or more of the second pixel circuits to which each of the plurality of first via holes correspond, are arranged on one axis.
(2) The light detection device according to (1), wherein
   each of the plurality of pixels includes:
   a photoelectric conversion element that accumulates a charge corresponding to the amount of incident light;
   a first transistor that switches between whether or not to transfer an accumulated charge of the photoelectric conversion element to a first floating diffusion region;
   a second transistor that switches between whether or not to initialize a charge of the first floating diffusion region; and
   a first source follower circuit that generates a voltage signal corresponding to the charge of the first floating diffusion region,
   each of the plurality of first pixel circuits includes:
      a first capacitance element that retains a voltage signal output from the first source follower circuit in a state where the charge of the first floating diffusion region of the corresponding pixel is initialized;
      a second capacitance element that retains a voltage signal output from the first source follower circuit in a state where the accumulated charge of the photoelectric conversion element is transferred to the first floating diffusion region of the corresponding pixel;
      a third transistor that switches between whether or not to transfer a charge retained by the first capacitance element to a second floating diffusion region; and
      a fourth transistor that switches between whether or not to transfer a charge retained by the second capacitance element to the second floating diffusion region, and
      each of the plurality of second pixel circuits includes:
         a fifth transistor that switches between whether or not to initialize a charge of the second floating diffusion region; and
         a second source follower circuit that generates a pixel signal corresponding to the charge of the second floating diffusion region.
(3) The light detection device according to (2), wherein each of the plurality of first via holes, the fifth transistor in the one or more of the second pixel circuits to which each of the plurality of first via holes corresponds, the second source follower circuit, and the fourth transistor, are arranged on one axis.
(4) The light detection device according to (2), wherein each of the plurality of first via holes, and the first transistor and the second transistor in the one or more of the first pixel circuits to which each of the plurality of first via holes corresponds, are arranged on one axis.
(5) The light detection device according to (2), wherein each of the plurality of first pixel circuits has a sixth transistor and a seventh transistor that precharge the first capacitance element and the second capacitance element, and
   each of the plurality of first via holes and the sixth and seventh transistors in the first pixel circuit to which each of the plurality of first via holes corresponds, are arranged on one axis.
(6) The light detection device according to any one of (2) to (5), wherein each of the plurality of pixels includes:
   a third capacitance element that accumulates part of the accumulated charge of the photoelectric conversion element; and
   an eighth transistor that switches between whether or not to accumulate part of the accumulated charge of the photoelectric conversion element in the third capacitance element.
(7) The light detection device according to any one of (2) to (6), wherein each of the plurality of pixels includes a ninth transistor that switches between whether or not to discharge the accumulated charge of the photoelectric conversion element.
(8) The light detection device according to any one of (1) to (7), wherein a diffusion layer of the transistor on the one axis that is adjacent to each of the plurality of first via holes is arranged between each of the plurality of first via holes and the transistor adjacent thereto on the one axis.
(9) The light detection device according to any one of (1) to (8), wherein each of the plurality of second pixel circuits is shared by two or more of the pixels and two or more of the first pixel circuits.
(10) The light detection device according to (9), wherein a unit pixel group region that includes the two or more of the first pixel circuits, one of the second pixel circuits, and one of the first via holes is provided, for each of the two or more of the pixels, and
   in the unit pixel group region, the first via holes and at least one transistor in the two or more of the first pixel circuits and the one of the second pixel circuits are arranged on one axis.
(11) The light detection device according to (10), wherein the second pixel circuit in the unit pixel group region generates a pixel signal corresponding to a voltage signal retained by the plurality of capacitance elements, and
   the first via hole transmits the pixel signal.
(12) The light detection device according to (10) or (11), wherein the unit pixel group region includes four of the first pixel circuits corresponding to a pixel group having two of the pixels in each of a first direction and a second direction, one of the second pixel circuits, and one of the first via holes, and
   the plurality of first via holes corresponding to a plurality of the unit pixel group regions are arranged at a substantially central portion of a boundary side of the unit pixel group region.
(13) The light detection device according to (10) or (11), wherein the unit pixel group region includes two of the first pixel circuits corresponding to a pixel group having one of the pixels in a first direction and two of the pixels in a second direction, one of the second pixel circuits, and one of the first via holes, and
   two of the unit pixel group regions arranged close to each other in the first direction are arranged out of alignment with each other in the first direction.
(14) The light detection device according to (13), wherein the two of the unit pixel group regions arranged close to each other in the first direction are arranged out of alignment in the first direction in such a manner that distances between the first via holes in the two of the unit pixel group regions and a transistor connected to the first via holes are equal.
(15) The light detection device according to any one of (1) to (11), wherein each of the plurality of second pixel circuits is provided to correspond to any of the plurality of first pixel circuits, and
   one of the first via holes is arranged for each of the plurality of second pixel circuits.
(16) The light detection device according to any one of (1) to (15), wherein each of the plurality of first via holes is arranged along a boundary side of two unit pixel regions adjacent to each other in the first direction or the second direction.
(17) An electronic apparatus, comprising:
   a light detection device that generates an image corresponding to an amount of incident light; and
   a processing unit that processes the image, wherein
   the light detection device includes:
      a plurality of pixels, each of which accumulates a charge corresponding to the amount of the incident light;
      a plurality of first pixel circuits that have a plurality of capacitance elements that retain, at the same timing, voltage signals corresponding to charges accumulated in the plurality of pixels;
      a plurality of second pixel circuits that generate pixel signals corresponding to charges retained by the plurality of capacitance elements;
      a logic circuit that performs signal processing on the plurality of pixel signals generated by the plurality of second pixel circuits;
      a first substrate on which the plurality of pixels are arranged;
      a second substrate that is laminated on the first substrate and on which the plurality of first pixel circuits and the plurality of second pixel circuits are arranged; and
      a third substrate that is laminated on the second substrate and on which the logic circuit is arranged, wherein
      the first substrate includes a plurality of first metal pads that are arranged opposite the second substrate and to which output nodes of the plurality of pixels are connected,
      the second substrate includes:
         a semiconductor layer arranged opposite the third substrate;
         a plurality of second metal pads joined to the plurality of first metal pads;
         a plurality of first via holes arranged to penetrate the semiconductor layer from the plurality of second pixel circuit; and
         a plurality of third metal pads arranged opposite the third substrate and connected to the plurality of first via holes, and
         the third substrate includes a plurality of fourth metal pads joined to the plurality of third metal pads,
         each of the plurality of first via holes is provided to correspond to one or more of the first pixel circuits and one or more of the second pixel circuits, and
         each of the plurality of first via holes and at least one transistor in the one or more of the first pixel circuits to which each of the plurality of first via holes correspond, or the one or more of the second pixel circuits to which each of the plurality of first via holes correspond, are arranged on one axis.

Aspects of the present disclosure are not limited to the aforementioned individual embodiments and include various modifications that could be conceived of by a person skilled in the art, and effects of the present disclosure are also not limited to those described above. In other words, various additions, modifications, and partial deletions are possible within the scope of the conceptual idea and intent of the present disclosure derived from the contents defined in the claims and their equivalents.

### [Reference Signs List]

- 1: Electronic apparatus
- 2: Imaging lens
- 3: Light detection device
- 3: Light detection device according to one embodiment
- 4: Image processing unit
- 5: Recording unit
- 6: Control unit
- 11: Pixel array unit
- 12: Vertical drive unit
- 13: and Column signal processing unit
- 13: Column signal processing unit
- 14: Timing control unit
- 15: Pixel
- 16: First pixel circuit
- 17: Second pixel circuit
- 21: Photoelectric conversion element
- 22: Transfer transistor
- 23: First reset transistor
- 24: First source follower circuit
- 25: First amplification transistor
- 26: First selection transistor
- 27: Conversion efficiency switching transistor
- 28: Charge retaining unit
- 29: Voltage switching device
- 30: Discharge transistor
- 31: First capacitance element
- 32: Second capacitance element
- 33: First sampling transistor
- 34: Second sampling transistor
- 35: Transistor group
- 36: Transistor group
- 37: Diffusion layer
- 41: Second reset transistor
- 42: Second source follower circuit
- 43: Second amplification transistor
- 44: Second selection transistor
- 45: Current source
- 50: First insulating layer
- 51: First substrate
- 52: Second substrate
- 53: Third substrate
- 54: Logic circuit
- 55: Peripheral circuit
- 56: First semiconductor layer
- 57: First wiring layer
- 58: Color filter
- 59: On-chip lens
- 60: Light shielding wall
- 61: Fixed charge film
- 62: Uneven structure
- 63: First metal pad
- 64: Second semiconductor layer
- 65: Second wiring layer
- 66: Third wiring layer
- 67: Second insulating layer
- 68: Second metal pad
- 70: Penetrating via hole
- 71: Third metal pad
- 72: Third semiconductor layer
- 73: Fourth wiring layer
- 74: Third insulating layer
- 75: Fourth metal pad
- 80: Sample-and-hold transistor
- 81: Charge retaining unit
- 82: Conversion efficiency switching transistor
- 83: Sample-and-hold transistor
- 84: Gate
- 85: Channel
- 86: Diffusion layer

## Claims

1. A light detection device, comprising:
a plurality of pixels, each of which accumulates a charge corresponding to an amount of incident light;
a plurality of first pixel circuits having a plurality of capacitance elements that retain, at the same timing, voltage signals corresponding to charges accumulated in the plurality of pixels;
a plurality of second pixel circuits that generate pixel signals corresponding to charges retained by the plurality of capacitance elements;
a logic circuit that performs signal processing on the plurality of pixel signals generated by the plurality of second pixel circuits;
a first substrate on which the plurality of pixels are arranged;
a second substrate that is laminated on the first substrate and on which the plurality of first pixel circuits and the plurality of second pixel circuits are arranged; and
a third substrate that is laminated on the second substrate and on which the logic circuit is arranged, wherein
the first substrate includes a plurality of first metal pads that are arranged opposite the second substrate and to which output nodes of the plurality of pixels are connected,
the second substrate includes:
a semiconductor layer arranged opposite the third substrate;
a plurality of second metal pads joined to the plurality of first metal pads;
a plurality of first via holes arranged to penetrate the semiconductor layer from the plurality of second pixel circuit; and
a plurality of third metal pads arranged opposite the third substrate and connected to the plurality of first via holes, and
the third substrate includes a plurality of fourth metal pads joined to the plurality of third metal pads,
each of the plurality of first via holes is provided to correspond to one or more of the first pixel circuits and one or more of the second pixel circuits, and
each of the plurality of first via holes and at least one transistor in the one or more of the first pixel circuits to which each of the plurality of first via holes correspond, or the one or
more of the second pixel circuits to which each of the plurality of first via holes correspond, are arranged on one axis.

2. The light detection device according to claim 1, wherein each of the plurality of pixels includes:
a photoelectric conversion element that accumulates a charge corresponding to the amount of incident light;
a first transistor that switches between whether or not to transfer an accumulated charge of the photoelectric conversion element to a first floating diffusion region;
a second transistor that switches between whether or not to initialize a charge of the first floating diffusion region; and
a first source follower circuit that generates a voltage signal corresponding to the charge of the first floating diffusion region,
each of the plurality of first pixel circuits includes:
a first capacitance element that retains a voltage signal output from the first source follower circuit in a state where the charge of the first floating diffusion region of the corresponding pixel is initialized;
a second capacitance element that retains a voltage signal output from the first source follower circuit in a state where the accumulated charge of the photoelectric conversion element is transferred to the first floating diffusion region of the corresponding pixel;
a third transistor that switches between whether or not to transfer a charge retained by the first capacitance element to a second floating diffusion region; and
a fourth transistor that switches between whether or not to transfer a charge retained by the second capacitance element to the second floating diffusion region, and
each of the plurality of second pixel circuits includes:
a fifth transistor that switches between whether or not to initialize a charge of the second floating diffusion region; and
a second source follower circuit that generates a pixel signal corresponding to the charge of the second floating diffusion region.

3. The light detection device according to claim 2, wherein each of the plurality of first via holes, the fifth transistor in the one or more of the second pixel circuits to which each of the plurality of first via holes corresponds, the second source follower circuit, and the fourth transistor, are arranged on one axis.

4. The light detection device according to claim 2, wherein each of the plurality of first via holes, and the first transistor and the second transistor in the one or more of the first pixel circuits to which each of the plurality of first via holes corresponds, are arranged on one axis.

5. The light detection device according to claim 2, wherein each of the plurality of first pixel circuits has a sixth transistor and a seventh transistor that precharge the first capacitance element and the second capacitance element, and
each of the plurality of first via holes and the sixth and seventh transistors in the first pixel circuit to which each of the plurality of first via holes corresponds, are arranged on one axis.

6. The light detection device according to claim 2, wherein each of the plurality of pixels includes:
a third capacitance element that accumulates part of the accumulated charge of the photoelectric conversion element; and
an eighth transistor that switches between whether or not to accumulate part of the accumulated charge of the photoelectric conversion element in the third capacitance element.

7. The light detection device according to claim 2, wherein each of the plurality of pixels includes a ninth transistor that switches between whether or not to discharge the accumulated charge of the photoelectric conversion element.

8. The light detection device according to claim 1, wherein a diffusion layer of the transistor on the one axis that is adjacent to each of the plurality of first via holes is arranged between each of the plurality of first via holes and the transistor adjacent thereto on the one axis.

9. The light detection device according to claim 1, wherein each of the plurality of second pixel circuits is shared by two or more of the pixels and two or more of the first pixel circuits.

10. The light detection device according to claim 9, wherein a unit pixel group region that includes the two or more of the first pixel circuits, one of the second pixel circuits, and one of the first via holes is provided, for each of the two or more of the pixels, and
in the unit pixel group region, the first via holes and at least one transistor in the two or more of the first pixel circuits and the one of the second pixel circuits are arranged on one axis.

11. The light detection device according to claim 10, wherein the second pixel circuit in the unit pixel group region generates a pixel signal corresponding to a voltage signal retained by the plurality of capacitance elements, and
the first via hole transmits the pixel signal.

12. The light detection device according to claim 10, wherein the unit pixel group region includes four of the first pixel circuits corresponding to a pixel group having two of the pixels in each of a first direction and a second direction, one of the second pixel circuits, and one of the first via holes, and
the plurality of first via holes corresponding to a plurality of the unit pixel group regions are arranged at a substantially central portion of a boundary side of the unit pixel group region.

13. The light detection device according to claim 10, wherein the unit pixel group region includes two of the first pixel circuits corresponding to a pixel group having one of the pixels in a first direction and two of the pixels in a second direction, one of the second pixel circuits, and one of the first via holes, and
two of the unit pixel group regions arranged close to each other in the first direction are arranged out of alignment with each other in the first direction.

14. The light detection device according to claim 13, wherein the two of the unit pixel group regions arranged close to each other in the first direction are arranged out of alignment in the first direction in such a manner that distances between the first via holes in the two of the unit pixel group regions and a transistor connected to the first via holes are equal.

15. The light detection device according to claim 1, wherein each of the plurality of second pixel circuits is provided to correspond to any of the plurality of first pixel circuits, and
one of the first via holes is arranged for each of the plurality of second pixel circuits.

16. The light detection device according to claim 1, wherein each of the plurality of first via holes is arranged along a boundary side of two unit pixel regions adjacent to each other in the first direction or the second direction.

17. An electronic apparatus, comprising:
a light detection device that generates an image corresponding to an amount of incident light; and
a processing unit that processes the image, wherein
the light detection device includes:
a plurality of pixels, each of which accumulates a charge corresponding to the amount of the incident light;
a plurality of first pixel circuits having a plurality of capacitance elements that retain, at the same timing, voltage signals corresponding to charges accumulated in the plurality of pixels;
a plurality of second pixel circuits that generate pixel signals corresponding to charges retained by the plurality of capacitance elements;
a logic circuit that performs signal processing on the plurality of pixel signals generated by the plurality of second pixel circuits;
a first substrate on which the plurality of pixels are arranged;
a second substrate that is laminated on the first substrate and on which the plurality of first pixel circuits and the plurality of second pixel circuits are arranged; and
a third substrate that is laminated on the second substrate and on which the logic circuit is arranged, wherein
the first substrate includes a plurality of first metal pads that are arranged opposite the second substrate and to which output nodes of the plurality of pixels are connected,
the second substrate includes:
a semiconductor layer arranged opposite the third substrate;
a plurality of second metal pads joined to the plurality of first metal pads;
a plurality of first via holes arranged to penetrate the semiconductor layer from the plurality of second pixel circuit; and
a plurality of third metal pads arranged opposite the third substrate and connected to the plurality of first via holes, and
the third substrate includes a plurality of fourth metal pads joined to the plurality of third metal pads,
each of the plurality of first via holes is provided to correspond to one or more of the first pixel circuits and one or more of the second pixel circuits, and
each of the plurality of first via holes and at least one transistor in the one or more of the first pixel circuits to which each of the plurality of first via holes correspond, or the one or more of the second pixel circuits to which each of the plurality of first via holes correspond, are arranged on one axis.
